(19)

Europäisches Patentamt
European Patent Office
Office européen des brevets

(11)  **EP 4 557 247 A1**

(12)  **EUROPEAN PATENT APPLICATION**
published in accordance with Art. 153(4) EPC

(43) Date of publication:
**21.05.2025  Bulletin 2025/21**

(21) Application number: **23855021.4**

(22) Date of filing: **27.06.2023**

(51) International Patent Classification (IPC):
**G06V 40/13** (2022.01)      **G06V 10/776** (2022.01)

(52) Cooperative Patent Classification (CPC):
**G06V 10/776; G06V 40/13**

(86) International application number:
**PCT/KR2023/008953**

(87) International publication number:
**WO 2024/039050 (22.02.2024 Gazette 2024/08)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **18.08.2022  KR 20220103079
13.09.2022  KR 20220114784**

(71) Applicant: **Samsung Electronics Co., Ltd.
Suwon-si, Gyeonggi-do 16677 (KR)**

(72) Inventor: **KIM, Jeonghoo
Suwon-si, Gyeonggi-do 16677 (KR)**

(74) Representative: **Gulde & Partner
Patent- und Rechtsanwaltskanzlei mbB
Berliner Freiheit 2
10785 Berlin (DE)**

(54)  **METHOD FOR DETECTING PERFORMANCE OF FINGERPRINT SENSOR AND ELECTRONIC DEVICE SUPPORTING SAME**

(57)  Embodiments of the present disclosure provide a method for detecting a change in performance of a fingerprint sensor due to a protective material, and an electronic device supporting same. An electronic device according to one embodiment may comprise a display, a fingerprint sensor formed under the display, memory, and a processor. The processor may operate to detect a designated trigger related to testing the performance of the fingerprint sensor. The processor may control the fingerprint sensor to acquire a designated image on the basis of detecting the designated trigger. The processor may extract reference data that is preset in the memory. The processor may operate to determine a state related to the protective material attachable to the display on the basis of the designated image acquired through the fingerprint sensor and the reference data. The processor may operate to determine whether the performance of the fingerprint sensor has changed, on the basis of the state related to the protective material. The processor may operate to perform a specified operation on the basis of whether the performance of the fingerprint sensor has changed.

FIG. 7

Flowchart:
- Start
- Detect specified trigger related to performance test of fingerprint sensor — 701
- Obtain image, based on fingerprint sensor — 703
- Extract preconfigured reference data — 705
- Analyze state, based on obtained image and reference data — 707
- Determine specified state, based on state analysis result — 709
- Perform specified operation, based on specified state — 711
- End

**Description**

[Technical Field]

Embodiments of the disclosure relate to a method for detecting a change in the performance of a fingerprint sensor and an electronic device supporting the same.

[Background Art]

With the advancement of digital technology, various types of electronic devices, such as a smartphone and/or a wearable device, are widely used. In order to support and improve the functions of electronic devices, electronic devices are continuously being developed in the aspect of hardware and/or software.

Electronic devices provide various security functions to protect users' privacy information or privacy, and a user-specific authentication method is developing for each electronic device. The security functions may include a fingerprint authentication method. For example, the fingerprint authentication method is easy to implement in an electronic device with a small form factor and has relatively high accuracy and security, thus being widely applied as an authentication method for electronic devices.

An electronic device may recognize a fingerprint by using a fingerprint sensor (or fingerprint reader). A fingerprint sensor included in an electronic device may be configured as a small fingerprint sensor that may be smaller than a user's fingerprint in order to reduce an effective surface area. In response to the expansion of a display area in recent years, a fingerprint sensor may be configured as an optical fingerprint sensor (e.g., an optical in-display fingerprint sensor) and be disposed under a display. The optical fingerprint sensor may have an under-panel sensor (UPS) (or an under-display sensor (UDS)) structure. According to an embodiment, the optical fingerprint sensor may refer to a sensor that photographs (or scans) a user's fingerprint by using a light source generated from the display.

For example, the fingerprint sensor (e.g., the optical fingerprint sensor) may be disposed under the display in an internal space of the electronic device to photograph (or scan) an external subject (e.g., a fingerprint) through at least a portion of the display and obtain a related image.

The fingerprint sensor may be subjected to a calibration process in the manufacturing process of an electronic device. For example, the fingerprint sensor is disposed under the display, and may thus be greatly affected by the stacked structure (e.g., a display panel layer, a touch screen panel (TSP) layer, a polarizer layer, an adhesive layer, or a glass layer) of the display (e.g., affected by a structural characteristic). To maintain optimal performance according to the stacked structure of the display, the fingerprint sensor may be subjected to the calibration process during the manufacturing process of the electronic device. For example, the fingerprint sensor may obtain a fingerprint image including great loss and distortion as light generated from the light source of the display is reflected from the user's fingerprint and passes through a plurality of layers of the display before entering the fingerprint sensor. In addition, the unique performance of the fingerprint sensor and the display may vary depending on electronic devices. Therefore, in order to minimize the foregoing errors and fix and extract a specified standard value for the fingerprint sensor, the calibration process for the fingerprint sensor may be performed in the manufacturing stage of the electronic device.

Users of electronic devices may attach a protective material, such as a protective film or protective glass, to a display to protect the display in use. In this case, due to the attachment of the protective film or protective glass, a stacked structure having a new characteristic may be added, and the recognition performance of the fingerprint sensor may be changed (deteriorated). For example, the fingerprint sensor is able to achieve optimal performance only when used by the user under the same condition as when the calibration process is performed. However, when many users use the fingerprint sensor with the protective material attached to protect the display, a stacked structure having a new characteristic may be added, causing a change in the performance.

[Disclosure of Invention]

[Technical Problem]

An embodiment of the disclosure may provide a method for detecting a change in the performance (e.g., deterioration) of a fingerprint sensor due to a protective material (e.g., a protective film or protective glass) of a display by using the fingerprint sensor of an electronic device and an electronic device supporting the same.

An embodiment of the disclosure may provide a method for detecting a protective material attached to a display of an electronic device and providing a guide on a change in the performance of a fingerprint sensor, based on a characteristic of the detected protective material and an electronic device supporting the same.

Technical aspects to be achieved in the disclosure are not limited to the technical aspects mentioned above, and other technical aspects not mentioned will be clearly understood by those skilled in the art to which the disclosure pertains from the following description.

[Solution to Problem]

An electronic device according to an embodiment may include a display, a fingerprint sensor disposed below the display, memory, and a processor operatively connected to the display, the fingerprint sensor, and the memory. According to an embodiment, the processor may operate to detect a specified trigger related to a performance test of the fingerprint sensor. According to an embodiment, the processor may control the fingerprint sensor to obtain a specified image, based on detecting the specified trigger. According to an embodiment, the processor may operate to extract reference data preconfigured in the memory. According to an embodiment, the processor may operate to determine a state related to a protective material attachable onto the display, based on the specified image obtained through the fingerprint sensor and the reference data. According to an embodiment, the processor may operate to determine whether performance of the fingerprint sensor is changed, based on the state related to the protective material. According to an embodiment, the processor may operate to perform a specified operation, based on whether the performance of the fingerprint sensor is changed.

An operating method of an electronic device according to an embodiment may include detecting a specified trigger related to a performance test of a fingerprint sensor disposed under a display. The operating method may include controlling the fingerprint sensor to obtain a specified image, based on detecting the specified trigger. The operating method may include extracting reference data preconfigured in memory of the electronic device. The operating method may include determining a state related to a protective material attachable onto the display, based on the specified image obtained through the fingerprint sensor and the reference data. The operating method may include determining whether performance of the fingerprint sensor is changed, based on the state related to the protective material. The operating method may include performing a specified operation, based on whether the performance of the fingerprint sensor is changed.

To achieve the foregoing aspects, an embodiment of the disclosure may include a computer-readable recording medium recording a program to cause a processor to execute the foregoing method.

According to an embodiment, a non-transitory computer-readable recording medium (or computer program product) storing one or more programs is described. According to an embodiment, the one or more programs may include instructions, when executed by a processor of an electronic device, to perform an operation of detecting a specified trigger related to a performance test of a fingerprint sensor disposed under a display, an operation of controlling the fingerprint sensor to obtain a specified image, based on detecting the specified trigger, an operation of extracting reference data preconfigured in memory of the electronic device, an operation of determining a state related to a protective material attachable onto the display, based on the specified image obtained through the fingerprint sensor and the reference data, an operation of determining whether performance of the fingerprint sensor is changed, based on the state related to the protective material, and an operation of performing a specified operation, based on whether the performance of the fingerprint sensor is changed.

The additional scope of the applicability of the disclosure will become apparent from the detailed description below. However, various changes and modifications within the spirit and scope of the disclosure may be clearly understood by those skilled in the art, and thus specific embodiments, such as the detailed description and exemplary embodiments of the disclosure, should be understood as given as examples.

[Advantageous Effects of Invention]

According to an electronic device, an operating method thereof, and a recording medium according to an embodiment of the disclosure, it is possible to detect a protective material (e.g., a protective film or protective glass) when the protective material is attached to a display of an electronic device, and to provide a user with a guide on the recognition performance of a fingerprint sensor according to the attachment of the protective material.

According to an electronic device, an operating method thereof, and a recording medium according to an embodiment of the disclosure, it is possible to detect whether a protective material is attached to a display by using a fingerprint sensor (e.g., an optical in-display fingerprint sensor) in a user-intended or un-intended situation.

According to an electronic device, an operating method thereof, and a recording medium according to an embodiment of the disclosure, it is possible to distinguish a protective material that is not suitable for the recognition performance of a fingerprint sensor of the electronic device, and may provide a user with a guide on the protective material that is not suitable.

According to an electronic device, an operating method thereof, and a recording medium according to an embodiment of the disclosure, it is possible for a user to easily recognize a change in the fingerprint recognition performance of a fingerprint sensor through a guide related to a protective material and support improvement of the performance when the performance deteriorates.

In addition, various effects directly or indirectly identified from the disclosure may be provided. Effects obtainable from the disclosure are not limited to the effects mentioned above, and other effects not mentioned will be clearly understood by those skilled in the art to which the disclosure pertains from the following description.

[Brief Description of Drawings]

In a description of drawings, the same or like reference numerals may be used for the same or like components.

FIG. 1 is a block diagram illustrating an example electronic device in a network environment according to various embodiments.

FIG. 2 is a reference view schematically illustrating an example of an electronic device according to an embodiment of the disclosure;

FIG. 3 is a reference view schematically illustrating an example in which a display and a fingerprint sensor are disposed in an electronic device according to an embodiment of the disclosure;

FIG. 4 is a reference view illustrating an example of a polarization transmission direction of a display in an electronic device according to an embodiment of the disclosure;

FIG. 5 is a reference view illustrating an example of a pattern for measuring a signal characteristic in an electronic device according to an embodiment of the disclosure;

FIG. 6 schematically illustrates the configuration of an electronic device according to an embodiment of the disclosure;

FIG. 7 is a flowchart illustrating an operating method of an electronic device according to an embodiment of the disclosure;

FIG. 8 is a flowchart illustrating an operating method of an electronic device according to an embodiment of the disclosure;

FIG. 9 is a flowchart illustrating an operating method of an electronic device according to an embodiment of the disclosure;

FIG. 10 is a flowchart illustrating an operating method of an electronic device according to an embodiment of the disclosure;

FIG. 11A and FIG. 11B are reference views illustrating an example in which an electronic device detects a protective material by using a background image according to an embodiment of the disclosure;

FIG. 12 is a reference view illustrating an example of a signal characteristic of a fingerprint sensor according to the presence or absence of a protective material in an electronic device according to an embodiment of the disclosure;

FIG. 13 is a reference view illustrating an example of an image processing result of an image obtained through a fingerprint sensor in an electronic device according to an embodiment of the disclosure;

FIG. 14 is a reference view illustrating an example of a change in a characteristic of a protective material in an electronic device according to an embodiment of the disclosure;

FIG. 15 is a reference view illustrating an example of a change in a characteristic of a protective material in an electronic device according to an embodiment of the disclosure;

FIG. 16 is a reference view illustrating an example in which an electronic device distinguishes a characteristic of a protective material according to an embodiment of the disclosure;

FIG. 17 is a flowchart illustrating an operating method of an electronic device according to an embodiment of the disclosure;

FIG. 18 is a flowchart illustrating an operating method of an electronic device according to an embodiment of the disclosure;

FIG. 19 is a reference view illustrating an example in which an electronic device detects a protective material by using a fingerprint image according to an embodiment of the disclosure;

FIG. 20A and FIG. 20B are reference views illustrating an example of an image pattern extracted based on a reference map and a fingerprint image in an electronic device according to an embodiment of the disclosure; and

FIG. 21 is a reference view illustrating an example in which an electronic device compares an image pattern based on a fingerprint image with a reference map according to an embodiment of the disclosure.

[Mode for the Invention]

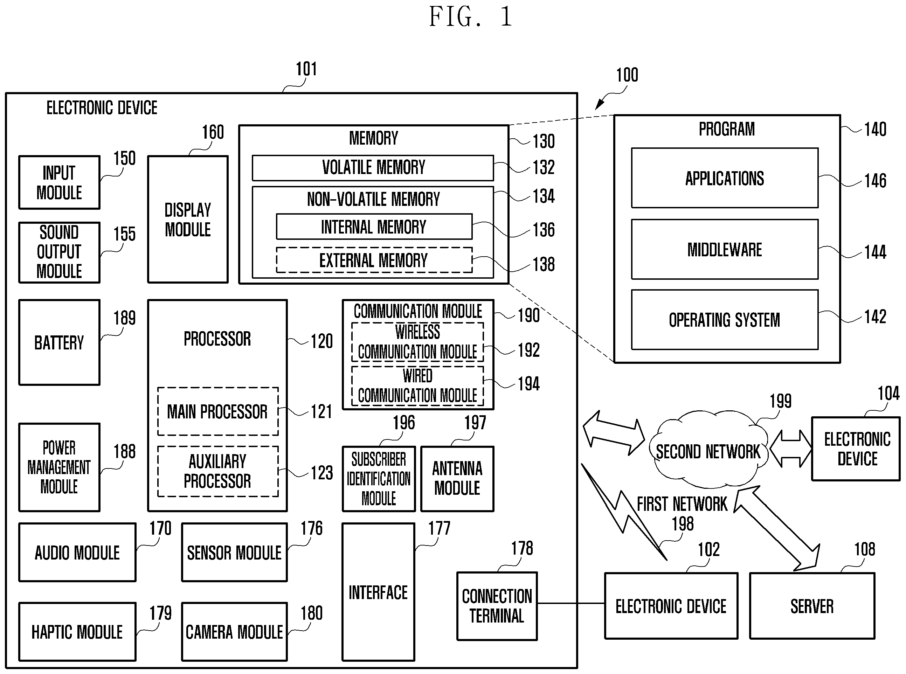

FIG. 1 is a block diagram illustrating an example electronic device 101 in a network environment 100 according to various embodiments.

Referring to FIG. 1, the electronic device 101 in the network environment 100 may communicate with an electronic device 102 via a first network 198 (e.g., a short-range wireless communication network), or at least one of an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module (SIM) 196, or an antenna module 197. In various embodiments, at least one of the components (e.g., the connecting terminal 178) may be omitted from the electronic device 101, or one or more other components may be added in the electronic device 101. In various embodiments, some of the components (e.g., the sensor module 176, the camera module 180, or the antenna module 197) may be implemented as a single component (e.g., the display module 160).

The processor 120 may execute, for example, software (e.g., a program 140) to control at least one other component (e.g., a hardware or software component) of the electronic device 101 coupled with the processor 120, and may perform various data processing or computation. According to an embodiment, as at least part of the data processing or computation, the processor 120 may store a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 101 includes the main processor 121 and the auxiliary processor 123, the auxiliary processor 123 may be adapted to consume less power than the main processor 121, or to be specific to a specified function. The auxiliary processor 123 may be implemented as separate from, or as part of the main processor 121.

The auxiliary processor 123 may control at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an embodiment, the auxiliary processor 123 (e.g., an image signal processor or a communication processor) may be implemented as part of another component (e.g., the camera module 180 or the communication module 190) functionally related to the auxiliary processor 123. According to an embodiment, the auxiliary processor 123 (e.g., the neural processing unit) may include a hardware structure specified for artificial intelligence model processing. An artificial intelligence model may be generated by machine learning. Such learning may be performed, e.g., by the electronic device 101 where the artificial intelligence is performed or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted Boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thereto. The memory 130 may include the volatile memory 132 or the non-volatile memory 134.

The program 140 may be stored in the memory 130 as software, and may include, for example, an operating system (OS) 142, middleware 144, or an application 146.

The input module 150 may receive a command or data to be used by another component (e.g., the processor 120) of the electronic device 101, from the outside (e.g., a user) of the electronic device 101. The input module 150 may include, for example, a microphone, a mouse, a keyboard, a key (e.g., a button), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 160 may visually provide information to the outside (e.g., a user) of the electronic device 101. The display module 160 may include, for example, a display, a hologram device, or a projector and control circuitry to control a corresponding one of the display, hologram device, and projector. According to an embodiment, the display module 160 may include a touch sensor adapted to detect a touch, or a pressure sensor adapted to measure the intensity of force incurred by the touch.

The audio module 170 may convert a sound into an electrical signal and vice versa. According to an embodiment, the audio module 170 may obtain the sound via the input module 150, or output the sound via the sound output module 155 or a headphone of an external electronic device (e.g., an electronic device 102) directly (e.g., wiredly) or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., wiredly) or wirelessly. According to an embodiment, the interface 177 may include, for example, a high definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the electronic device 102). According to an embodiment, the connecting terminal 178 may include, for example, a HDMI connector, a USB connector, a SD card connector, or an audio connector (e.g., a headphone connector).

The haptic module 179 may convert an electrical signal into a mechanical stimulus (e.g., a vibration or a movement) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to an embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device via the first network 198 (e.g., a short-range communication network, such as BluetoothTM, wireless-fidelity (Wi-Fi) direct, or infrared data association (IrDA)) or the second network 199 (e.g., a long-range communication network, such as a legacy cellular network, a 5G network, a next-generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 192 may identify and authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 197 may transmit or receive a signal or power to or from the outside (e.g., the external electronic device) of the electronic device 101. According to an embodiment, the antenna module 197 may include an antenna including a radiating element including a conductive material or a conductive pattern formed in or on a substrate (e.g., a printed circuit board (PCB)). According to an embodiment, the antenna module 197 may include a plurality of antennas (e.g., array antennas). In such a case, at least one antenna appropriate for a communication scheme used in the communication network, such as the first network 198 or the second network 199, may be selected, for example, by the communication module 190 (e.g., the wireless communication module 192) from the plurality of antennas. The signal or the power may then be transmitted or received between the communication module 190 and the external electronic device via the selected at least one antenna. According to an embodiment, another component (e.g., a radio frequency integrated circuit (RFIC)) other than the radiating element may be additionally formed as part of the antenna module 197.

According to various embodiments, the antenna module 197 may form a mmWave antenna module. According to an embodiment, the mmWave antenna module may include a printed circuit board, a RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. Each of the electronic devices 102 or 104 may be a device of a same type as, or a different type, from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra-low-latency services using, e.g., distributed computing or mobile edge computing. In an embodiment, the external electronic device 104 may include an internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or healthcare) based on 5G communication technology or IoT-related technology.

The electronic device according to various embodiments may be one of various types of electronic devices. The electronic devices may include, for example, a portable communication device (e.g., a smartphone), a computer device, a portable multimedia device, a portable medical device, a camera, a wearable device, a home appliance, or the like. According to an embodiment of the disclosure, the electronic devices are not limited to those described above.

It should be appreciated that various embodiments of the disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise. As used herein, each of such phrases as "A or B," "at least one of A and B," "at least one of A or B," "A, B, or C," "at least one of A, B, and C," and "at least one of A, B, or C," may include any one of, or all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," "coupled to, " "connected with," or "connected to" another element (e.g., a second element), the element may be coupled with the other element directly (e.g., wiredly), wirelessly, or via a third element.

As used in connection with various embodiments of the disclosure, the term "module" may include a unit implemented in hardware, software, or firmware, or any combination thereof, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in a form of an application-specific integrated circuit (ASIC).

Various embodiments as set forth herein may be implemented as software (e.g., the program 140) including one or more instructions that are stored in a storage medium (e.g., internal memory 136 or external memory 138) that is readable by a machine (e.g., the electronic device 101). For example, a processor (e.g., the processor 120) of the machine (e.g., the electronic device 101) may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a complier or a code executable by an interpreter. The machine-readable storage medium may be provided in the form of a non-transitory storage medium. Wherein, the "non-transitory" storage medium is a tangible device, and may not include a signal (e.g., an electromagnetic wave), but this term does not differentiate between where data is semi-permanently stored in the storage medium and where the data is temporarily stored in the storage medium.

According to an embodiment, a method according to various embodiments of the disclosure may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store (e.g., PlayStore™), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

According to various embodiments, each component (e.g., a module or a program) of the above-described components may include a single entity or multiple entities, and some of the multiple entities may be separately disposed in different components. According to various embodiments, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

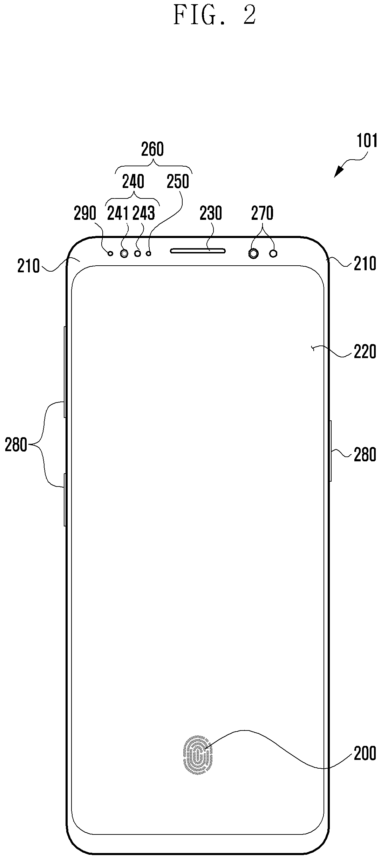

FIG. 2 is a reference view schematically illustrating an example of an electronic device according to an embodiment of the disclosure.

Referring to FIG. 2, the electronic device 101 (e.g., the electronic device 101 of FIG. 1) according to the embodiment may include a housing 210, a display 220 (e.g., the display module 160 of FIG. 1), a sound output module 230 (e.g., the sound output module 155 of FIG. 1), a sensor module 260 (e.g., the sensor module 176 of FIG. 1), a camera module 270 (e.g., the camera module 180 of FIG. 1), a key input device 280 (e.g., the input module 150 of FIG. 1), an indicator 290, and/or a fingerprint sensor 200. In an embodiment, the electronic device 101 may omit at least one (e.g., the key input device 280 or the indicator 290) of the components, or may additionally include other components.

According to an embodiment, FIG. 2 illustrates an example in which at least one of the sensor module 260 including a proximity sensor and/or an illuminance sensor, the sound output module 230, and/or the camera module 270 is mounted on a front plate (e.g., the housing 210) of the electronic device 101, the disclosure is not limited thereto. For example, although not illustrated, the sensor module 260, the sound output module 230, and/or the camera module 270 may be configured in a structure of being disposed under the display 220 of the electronic device 101 (e.g., on an under panel). For example, when viewing the display 220 from a front surface of the housing 210, the sensor module 260, the sound output module 230, and/or the camera module 270 may be disposed under the display 220 between the front surface of the housing 210 and a rear surface opposite the front surface. In an embodiment, at least some of the sensor module 260, the sound output module 230, and/or the camera module 270 may be disposed in at least an area of the display 220.

According to an embodiment, the sensor module 260, the sound output module 230, and/or the camera module 270 may be disposed in a space formed by the housing 210 of the electronic device 101, and may be exposed to the outside through at least one hole (or opening) formed in the housing 210 and/or the display 220. For example, the display 220 of the electronic device 101 may be configured in a design in which an area occupied on the front surface is increased (e.g., as a bezel-less display), and various components (e.g., the sensor module 260, the audio output module 230, and/or the camera module 270) disposed on the front surface may be disposed between the display 220 and the rear surface (e.g., a second surface) (or under the display 220), or may be disposed inside the display 220. For example, the electronic device 101 may be configured in an under-display sensor structure such that various components are disposed between the display 220 and the rear surface (or under the display 220 (e.g., on the under panel)). According to an embodiment, the electronic device 101 may be configured in an in-display sensor structure such that various components are configured integrally with the display 220 and disposed within the display 220.

According to an embodiment, the housing 210 may refer to an external part surrounding the electronic device 101. For example, the housing 210 may include a first surface (or front surface), a second surface (or rear surface) facing the first surface, and a lateral surface (e.g., a lateral member) surrounding a space between the first surface and the second surface. According to an embodiment, the first surface may be formed of a front plate of which at least a portion is substantially transparent (e.g., a glass plate including various coating layers or a polymer plate). In an embodiment, the second surface may be formed of a substantially opaque rear plate. In an embodiment, the rear plate may be formed of a coated or colored glass, ceramic, a polymer, metal (e.g., aluminum, stainless steel (STS), or magnesium), or a combination of at least two of the foregoing materials. In an embodiment, the lateral surface may be formed of a lateral bezel structure (or lateral member) that is coupled to the front plate and the rear plate and includes metal and/or polymer.

According to an embodiment, the display 220 (e.g., the display module 160 of FIG. 1) may be disposed, for example, on the first surface (e.g., the front plate) of the housing 210 and exposed to the outside. The display 220 may be coupled with or disposed adjacent to a touch sensor (or touch detection circuit), a pressure sensor capable of measuring the intensity (pressure) of a touch, and/or a digitizer capable of detecting a digital pen (e.g., a stylus pen) of a magnetic field type. According to an embodiment, the display 220 may be configured in various forms including a liquid crystal display (LCD), an organic light-emitting diode (OLED), or an active-matrix OLED (AMOLED). The display 220 may display various images (e.g., a video and/or a still image), based on control of a processor (e.g., the processor 120 of FIG. 1), and may receive an input by various external objects (e.g., a human hand and/or a digital pen) on the display 220. The display 220 may include a touch sensor (not shown) to receive an input by various external objects.

According to an embodiment, the touch sensor may be configured as a layer independent of a display panel of the display 220, or may be configured in a structure of being integrated with the display panel. The touch sensor may receive a first touch (e.g., a contact touch input) implemented by direct contact between an external object and the display 220 or a second touch (e.g., a proximity input) implemented by an external object and the display 220 not being in contact but being in proximity to each other (e.g., a hovering).

According to an embodiment, the sound output module 230 may include a speaker. The speaker may include a receiver for a call. According to an embodiment, the sound output module 230 may be disposed on the edge of a bezel area (or dead space) of the electronic device 101, or may include an under-panel speaker using the display 220 (e.g., OLED) as a diaphragm. For example, the under-panel speaker may be disposed under the display 220, thus not being visible externally.

According to an embodiment, the sensor module 260 may generate an electric signal or a data value corresponding to an internal operating state of the electronic device 101 or an external environmental state. The sensor module 260 may include, for example, a first sensor module 240 (e.g., the proximity sensor) and/or a second sensor module 250 (e.g., the illuminance sensor) disposed on the first surface of the housing 210 and/or a third sensor module (not shown) (e.g., the fingerprint sensor) disposed on the second surface of the housing 210. According to an embodiment, the first sensor module 240 (e.g., the proximity sensor) may detect an external object approaching the electronic device 101. The first sensor module 240 may include a light-emitting unit 241 that emits infrared rays and a light-receiving unit 243 that receives infrared rays reflected by an external object. According to an embodiment, the second sensor module 250 (e.g., the illuminance sensor) may measure the ambient (surrounding) illuminance (e.g., ambient light) of the electronic device 101. According to an embodiment, the second sensor module 250 may measure the illuminance by measuring the amount of light through a hole formed in advance.

According to an embodiment, the camera module 270 may include a first camera module 270 disposed on a first surface of the electronic device 101, and/or a second camera module (not shown) disposed on a second surface, and/or a flash (not shown). The camera module 270 may include one lens or a plurality of lenses, an image sensor, and/or an image signal processor. According to an embodiment, the flash may include a light-emitting diode or a xenon lamp. According to an embodiment, two or more lenses (e.g., wide-angle and telephoto lenses) and image sensors may be disposed on one surface of the electronic device 101.

According to an embodiment, the key input device 280 may be disposed on the lateral surface of the housing 210. In an embodiment, the electronic device 101 may not include a part or the entirety of the key input device 280, and a key input device 280 not included may be configured in another form, such as a soft key, on the display 220. In an embodiment, the key input device 280 may be configured using the touch sensor and/or the pressure sensor included in the display 220.

According to an embodiment, the indicator 290 may be disposed on the first surface of the housing 210. The indicator 290 may provide state information about the electronic device 101 in the form of light. For example, the indicator 290 may provide an LED state indicator (e.g., a pilot lamp or an indicating lamp). In an embodiment, the indicator 290 may provide a light source linked with an operation of the camera module 270. In an embodiment, the indicator 290 may include a light-emitting element, such as an LED, an IR LED, and/or a xenon lamp.

Although not shown, the electronic device 101 may include an input module (not shown) and/or a connector hole (not shown). The input module may include a plurality of microphones disposed to detect the direction of a sound. The connector hole may include a first connector hole capable of accommodating a connector (e.g., a USB connector) for transmitting and receiving power and/or data to and from an external electronic device and/or a second connector hole (or an earphone jack) capable of accommodating a connector for transmitting and receiving an audio signal to and from an external electronic device. According to an embodiment, the electronic device 101 may further include a sensor module (e.g., the sensor module 176 of FIG. 1) not illustrated, for example, at least one of a gesture sensor, a gyro sensor, an atmospheric pressure sensor, a magnetic sensor, an acceleration sensor, a grip sensor, a color sensor, an infrared (IR) sensor, a biometric sensor, a temperature sensor, or a humidity sensor.

According to an embodiment, the electronic device 101 may provide a fingerprint recognition (e.g., fingerprint-on-display (FOD) or in-display fingerprint) (hereinafter, referred to as "display fingerprint recognition") function on the display 220. For example, the electronic device 101 may include the fingerprint sensor 200 (e.g., a display fingerprint sensor) in a portion between the display 220 and the second surface (or under the display 220 (e.g., on the under panel)) (or in the space formed by the housing 210). According to an embodiment, the fingerprint sensor 200 may be disposed between the display 220 disposed on the front surface (e.g., the first surface) of the electronic device 101 and the rear surface (e.g., the second surface). According to an embodiment, the electronic device 101 may be configured to further include a button-type fingerprint sensor (e.g., a fingerprint sensor disposed on a physical button on the second surface or lateral surface) together with the display fingerprint sensor.

According to an embodiment, the electronic device 101 may provide fingerprint recognition, based on the fingerprint sensor 200. According to an embodiment, the fingerprint sensor 200 may be configured to recognize a fingerprint by using a light source of the display 220 in a state of being disposed under the display 220 (e.g., on the under panel) not to be exposed to the outside. For example, the electronic device 101 may dispose the fingerprint sensor 200 on a rear surface of the display (e.g., the bottom of a display panel), and may recognize a fingerprint being in contact with (or touching) a front surface (e.g., a display surface (or screen)) of the display. According to an embodiment, the fingerprint sensor 200 may use an optical method for obtaining a fingerprint image (or picture) reflected by visible light. For example, the optical method may refer to a method of shining light on a platen and recognizing an image of a fingerprint reflected according to the form of a fingerprint of a fingertip placed on the platen.

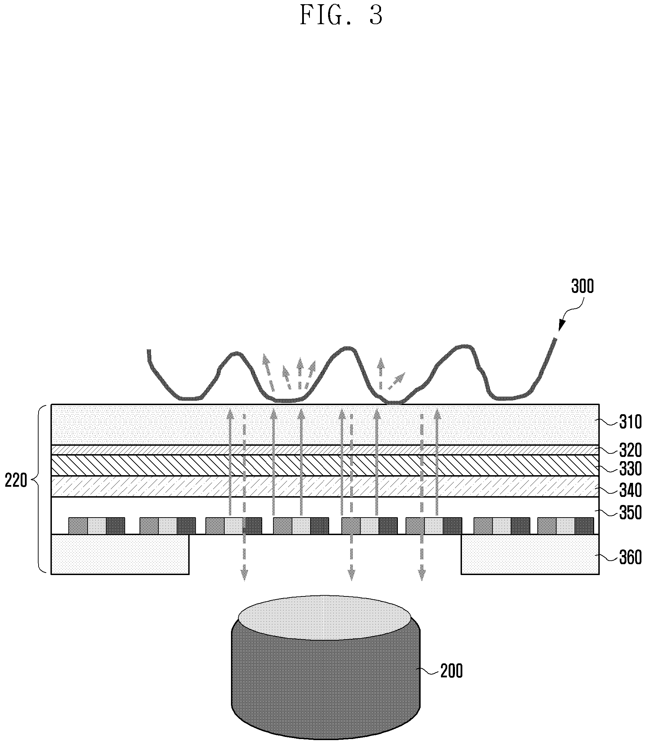

FIG. 3 is a reference view schematically illustrating an example in which a display and a fingerprint sensor are disposed in an electronic device according to an embodiment of the disclosure.

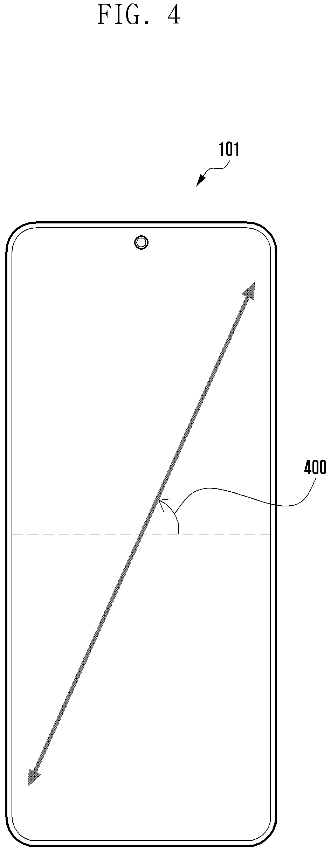

FIG. 4 is a reference view illustrating an example of a polarization transmission direction of a display in an electronic device according to an embodiment of the disclosure.

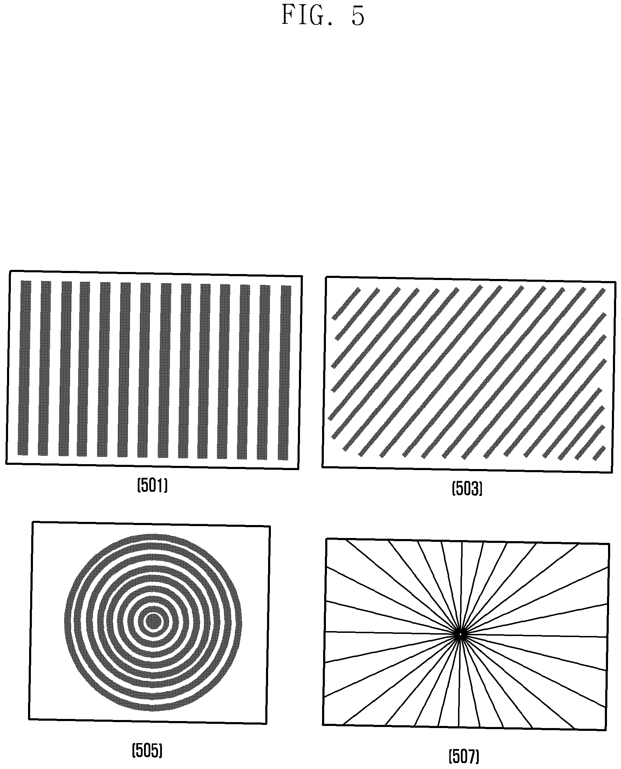

FIG. 5 is a reference view illustrating an example of a pattern for measuring a signal characteristic in an electronic device according to an embodiment of the disclosure.

According to an embodiment, FIG. 3 may illustrate an example in which a fingerprint sensor 200 (e.g., an optical in-display fingerprint sensor) is disposed under a display 220.

As illustrated in FIG. 3, the display 220 according to an embodiment may include various layers, such as a glass 310, an adhesive 320, a polarizer 330, a touch screen panel (TSP) 340, a display panel 350, and a copper sheet 360.

According to an embodiment, the fingerprint sensor 200 may be configured to recognize a fingerprint by using a light source of the display 220. For example, light generated from the display panel 350 within a structure of the display 220 may pass through the plurality of layers (e.g., the TSP 340, the polarizer 330, the adhesive 320, and the glass 310) of the display 220 and then enter a user's fingerprint 300 that is in contact with the surface of the display 220. The refractive index of the glass 310 that comes in direct contact with the fingerprint 300 may be similar to that of the user's skin, and may have a relatively large difference from the refractive index of an air layer. For example, the refractive index of the glass 310 may be about 1.5, the refractive index of the skin may be about 1.4, and the refractive index of the air layer may be about 1.0.

According to an embodiment, since light is reflected according to a large difference in refractive index and passes according to similar refractive indices, the light entering the fingerprint 300 may be mostly reflected from valleys of the fingerprint 300 to head back toward the display 220, and light entering ridges of the fingerprint 300 may be absorbed by the user's finger. The light reflected from the valleys of the fingerprint 300 may pass through all layers of the display 220 and be received by the fingerprint sensor 200, thus obtaining a fingerprint image.

The light generated from the display panel 350 may reach the user's fingerprint 300 through the plurality of layers in the display 220 in a process of the light reaching the user's fingerprint, be reflected from the valleys, and reach the fingerprint sensor 200 through the plurality of layers. Among the plurality of layers of the display 220, the display panel 350 and the polarizer 330 may have a significant effect on the fingerprint sensor 200. For example, the display panel 350 is formed in a specific metal pattern, may affect a transmission characteristic, a frequency characteristic, and a noise characteristic of the light received by the fingerprint sensor 200, and may affect image quality.

For example, the polarizer 330 applied to clarify a black color in the display 220 and to accurately distinguish a color outdoors may render the light in a random direction generated from the light source of the display panel into a linear polarization characteristic of proceeding only in a certain direction, thus transmitting the light to the user's fingerprint. The light reflected from the user's fingerprint may pass back through the polarizer 330 to be transmitted to the fingerprint sensor 200.

As illustrated in FIG. 4, the polarizer 330 may generally have a transmission angle 400 of about 45 degrees or about 135 degrees, and may be included in the display 220. Depending on the transmission angle 400 of the polarizer 330, only light polarized in a specific direction may pass through the polarizer 330 and light in other directions may be blocked.

For example, light may generally be changed to linear polarization while passing through the polarizer 330 aligned at about 45 degrees.

As described above, an image (e.g., a fingerprint image) obtained through the fingerprint sensor 200 may be generated including loss and distortion as the light generated from the light source of the display panel 350 is reflected from the user's fingerprint 300 and enters the fingerprint sensor 200 through the plurality of layers. Unique performances of the fingerprint sensor 200 and the display 220 may have a deviation in manufacture of the electronic device 101. Therefore, to minimize errors in the unique performances to fix and extract a desired standard value, a calibration may be performed on the fingerprint sensor 200 in the manufacturing stage of the electronic device 101.

According to an embodiment, in a calibration process of the fingerprint sensor 200, various pieces of information, such as image capture time information, sensor signal/noise information, a background image, sensor pixel information, lens magnification information, and/or additional information identifiable through the image, may be obtained. In an embodiment, the image capture time may indicate information about the amount of light of the display 220, a transmission characteristic, and/or the sensitivity of the sensor. In an embodiment, sensor signal/noise may indicate information about the contrast (or difference) of a specific pattern that is finally obtained. In an embodiment, the background image may indicate an image displayed by a display pattern, the amount of light, and/or a display stack.

According to an embodiment, the electronic device 101 may use at least one calibration kit (or groove tool) to obtain the foregoing various pieces of information in the calibration.

According to an embodiment, in the manufacture of the electronic device 101, the calibration may be performed using the calibration kit, for example, at least one of three tools: a reflective-color groove tool (e.g., an apricot groove tool), an absorbing-color groove tool (e.g., a black groove tool), and/or a reflective-color specific-pattern tool (e.g., an apricot stripe tool). According to an embodiment, a reflective color may be white, and an absorbing color may be black.

According to an embodiment, the reflective-color groove tool may refer to a tool or a corresponding environment for measuring light reflected from a groove tool. According to an embodiment, the absorbing-color groove tool may refer to a tool or a corresponding environment (e.g., a darkroom) for measuring backlight of the display 220. According to an embodiment, the absorbing-color groove tool may be used to obtain a background image through the fingerprint sensor 200. According to an embodiment, the reflected-color specific-pattern tool may be used to obtain information for determining a signal characteristic and a pattern.

According to an embodiment, various pieces of information (e.g., reference data) including saturation time, magnification, foreign matter attachment, a signal characteristic, and a display back pattern characteristic (or back image characteristic) of the fingerprint sensor 200 may be obtained through the calibration. In an embodiment, the various pieces of information may be stored in the memory 130 or memory (not shown) provided in the fingerprint sensor 200. In an embodiment, the saturation time may refer to exposure time to reach the maximum of electrons that a pixel of the fingerprint sensor 200 is able to store. In an embodiment, the magnification may refer to the ratio between the actual size of a fingerprint and the size of an image received by the fingerprint sensor 200. In an embodiment, the foreign matter attachment may refer to whether there is a foreign matter or damage on the fingerprint sensor 200 or a path through which light passes during the manufacture of the electronic device 101.

In an embodiment, the signal characteristic may refer to the level of a signal characteristic entering the fingerprint sensor 200. For example, the signal characteristic may be measured using a specified pattern (e.g., a pattern in which white and black alternate) as illustrated in FIG. 5. For example, black may act as a ridge of a fingerprint coming into contact with the display 220, and white may act as a valley of the fingerprint with an air layer. The signal characteristic may be distinguished depending on how accurately distinction between white and black is expressed in this pattern.

In an embodiment, a display back pattern may be background information at a time of imaging the fingerprint sensor 200, and may refer to a shape generated when the light source passes through the polarizer 330 and the display panel 350. This shape may function as a fixed form, and may be used to improve image quality when a user attempts to recognize a fingerprint and obtains a fingerprint image. According to an embodiment, as described above, in the fingerprint sensor 200 of the electronic device 101, the quality of an obtained image may be affected by a characteristic of the display 220, and a calibration may be performed for compensation.

As discussed above, the fingerprint sensor 200 may be greatly affected by the stacked structure of the display 220. Therefore, the fingerprint sensor 200 may exhibit optimal performance when used under the same condition as in which the calibration is performed during the manufacturing stage. However, users of the electronic device 101 may attach a protective material, such as a protective film or protective glass, to the display 220 to protect the display 220 in use. In this case, due to the addition of the protective material, a stacked structure having a new characteristic may be formed, and the performance of the fingerprint sensor 200 may be changed.

According to an embodiment, the protective film may include a structure in which an adhesive component and polyester (PET) are stacked on the top of the display 220. According to an embodiment, the protective glass may include a structure in which an adhesive component, a shatter-proof film, and glass are stacked on the top of the display 220. In the protective material, for example, PET or the shatter-proof film, and some adhesive components may have a polarizing characteristic (e.g., a retarding characteristic (e.g., phase retardation)). For example, the protective material may exhibit the retarding characteristic in a specific direction by various factors (e.g., expansion, heat, and/or pressure) in a manufacture process thereof.

In an embodiment, the retarding characteristic may refer to a phenomenon in which the phase of a wave proceeding in a specific axis (e.g., an x-axis and/or y-axis) is delayed. For example, the retarding characteristic may refer to a phenomenon in which the phase of light is delayed in a specific direction when the light passes through a molecular structure of a specific type. According to an embodiment, in the protective material, the retarding characteristic may cause no loss of signal intensity, but may delay the phase in the specific axis direction. For example, the protective material may exhibit the retarding characteristic in width and length directions thereof. In an embodiment, the protective material may delay a specific direction in which light proceeds by about 90 degrees (e.g., convert linearly polarized light to circularly polarized light or convert circularly polarized light to linearly polarized light).

According to an embodiment, as described above, in the fingerprint sensor 200, the retarding characteristic of the protective material may change the recognition performance of the fingerprint sensor 200 (e.g., decrease the recognition performance).

According to an embodiment, when not aligned with the direction of the polarizer 330 (e.g., a linear polarizer) of the display 220, the retarding characteristic of the protective material may change a specific direction of the light source with a linear polarization characteristic from the polarizer 330 into an elliptical polarization characteristic by delaying (or retarding) a phase. The changed elliptical polarization characteristic may be reflected from the fingerprint and changed back into the linear polarization characteristic when passing through the polarizer 330 of the display 220.

For example, the polarizer 330 (e.g., the linear polarizer) of the display 220 may pass a linearly polarized signal proceeding at a specified angle without loss. However, when an elliptically polarized signal is input to the polarizer 330, the elliptically polarized signal may be attenuated. For example, the signal may be lost while an elliptical polarization characteristic changes to a linear polarization characteristic, which may cause a decrease in signal-to-noise ratio (SNR) to affect the recognition performance of the fingerprint sensor 200. For example, the resolution of the fingerprint sensor 200 in distinguishing ridges and valleys of a fingerprint image may be reduced.

The retarding characteristic occurring in the protective material may differ depending on the manufacturer, the process, and the material of the protective material, and may not be distinguished in appearance. Therefore, when a polarization characteristic of the protective material does not match the passing direction of the polarizer 330 in the display 220 of the electronic device 101, a signal transmitted to the fingerprint sensor 200 may be significantly attenuated. This result may cause a change in the recognition performance of the fingerprint sensor 200 (e.g., deterioration in the performance).

The electronic device 101 according to an embodiment of the disclosure may detect whether the protective material is present by using a polarization characteristic of the display 220 under a specified condition. When detecting the attachment of the protective material, the electronic device 101 according to an embodiment of the disclosure may determine a characteristic of the protective material that may affect the fingerprint recognition performance of the fingerprint sensor 200. When determining the deterioration in the recognition performance of the fingerprint sensor 200, based on the characteristic of the protective material, the electronic device 101 according to an embodiment of the disclosure may provide the user with a guide to the change in the fingerprint recognition performance due to the protective material. Accordingly, the user may handle the deterioration in the fingerprint recognition performance due to the protective material, thereby maintaining or improving the recognition performance of the fingerprint sensor 200.

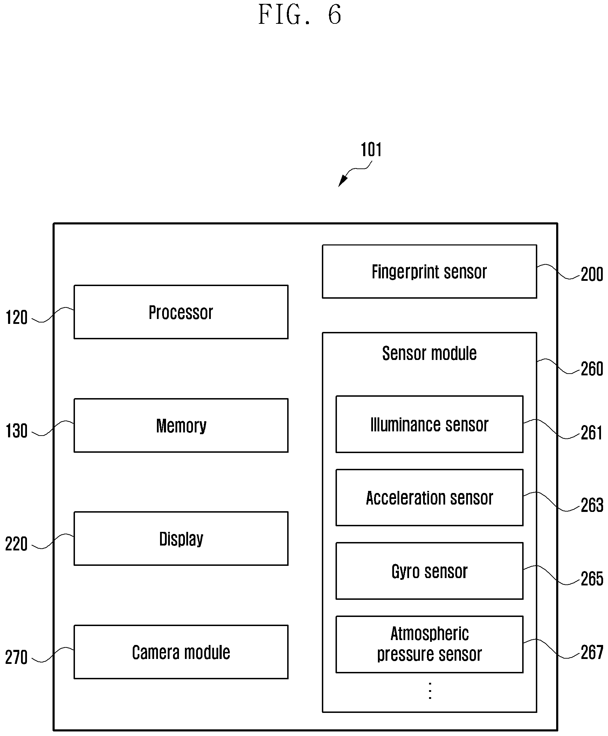

FIG. 6 schematically illustrates the configuration of an electronic device according to an embodiment of the disclosure.

The electronic device 101 according to an embodiment of the disclosure may include various devices in which a fingerprint sensor may be disposed under a display 220. According to an embodiment, the electronic device 101 may include various devices, such as a smartphone, a wearable device, a digital camera, a multimedia player, or a portable computer. Although the electronic device 101 is described as a smartphone in an embodiment of the disclosure for convenience of explanation, various embodiments according to the disclosure are not limited to a smartphone.

According to an embodiment, a fingerprint sensor 200 may recognize a fingerprint input by a user. According to an embodiment, the fingerprint sensor 200 may obtain an image (or fingerprint feature) of a fingerprint representing a unique characteristic difference of the user. According to an embodiment, the fingerprint sensor 200 may obtain a fingerprint image by various methods, such as an optical method, a semiconductor element method that detects electrostatic capacity or electrical conductivity, an ultrasonic method, a heat detection method, a non-contact method, and/or a combination of these methods.

According to an embodiment, the fingerprint sensor 200 may include a sensor that receives light and converts the light into an electrical signal (e.g., an optical fingerprint sensor). According to an embodiment, a light source used as a signal in the fingerprint sensor 200 may be a light source within the display 220. According to an embodiment, a first light source used in a calibration related to the fingerprint sensor 200 in the manufacturing stage of the electronic device 101 and a second light source used in a test for the performance of the fingerprint sensor 200 in an environment where the user uses the electronic device 101 may have substantially the same color (e.g., a combination of red (R), green (G), and blue (B)) and/or brightness (e.g., brightness within a range that the display 220 is able to generate).

According to an embodiment, a processor 120 may control an operation of the electronic device 101. According to an embodiment, the processor 120 may control an operation related to performing a function according to fingerprint recognition. According to an embodiment, the processor 120 may be operatively connected to a display module 160, the fingerprint sensor 200, and/or memory 130, and may control the display module 160, the fingerprint sensor 200, and/or the memory 130. According to an embodiment, the processor 120 may be configured as one or more processors that execute one or more programs (or instructions) stored in the memory 130 to control the operation of the electronic device 101 of various embodiments. According to an embodiment, the processor 120 may include at least one processor among an application processor (AP), a communication processor (CP), and/or a supplementary processor.

Referring to FIG. 6, the electronic device 101 according to an embodiment of the disclosure may include the processor 120, the memory 130, the fingerprint sensor 200, the display 220, a sensor module 260, and/or a camera module 270. According to an embodiment, the electronic device 101 may not include at least one component (e.g., the camera module 270). According to an embodiment, the electronic device 101 may include one or more other components (e.g., the communication module 190, the power management module 188, and/or the battery 189 of FIG. 1). For example, the electronic device 101 may include all or at least some of the components of the electronic device 101 described with reference to FIG. 1, FIG. 2, and FIG. 3.

According to an embodiment, the display 220 (e.g., the display module 160 of FIG. 1 or the display 220 of FIG. 2) may visually provide various pieces of information to the outside (e.g., a user) of the electronic device 101. According to an embodiment, the display 220 may visually provide various pieces of information related to a change in recognition performance of the fingerprint sensor 200 due to a protective material under control of the processor 120.

According to an embodiment, the display 220 may include a touch detection circuit (or touch sensor) (not shown), a pressure sensor capable of measuring the intensity of a touch, and/or a touch panel (e.g., a digitizer) that detects a stylus pen of a magnetic field type. According to an embodiment, the display 220 may detect a touch input and/or a hovering input (or a proximity input) by measuring a change in a signal (e.g., voltage, light amount, resistance, electromagnetic signal, and/or charge amount) at a specific position of the display 220, based on the touch detection circuit, the pressure sensor, and/or the touch panel. According to an embodiment, the display 220 may include a liquid crystal display (LCD), an organic light-emitting diode (OLED), or an active-matrix OLED (AMOLED). According to an embodiment, the display 220 may include a flexible display.

According to an embodiment, the memory 130 may correspond to the memory 130 described with reference to FIG. 1. According to an embodiment, the memory 130 may store various data used by the electronic device 101. In an embodiment, the data may include, for example, an application (e.g., the program 140 of FIG. 1), and input data or output data about a command related to the application.

In an embodiment, the data may include various sensor data (e.g., acceleration sensor data, gyro sensor data, or atmospheric pressure sensor data) obtained from the sensor module 260. In an embodiment, the data may include data (e.g., a fingerprint image and/or a background image) obtained from the fingerprint sensor 200. In an embodiment, the data may include various reference data (e.g., a reference background image, a reference fingerprint image, and/or a reference map) related to the fingerprint sensor 200 configured in advance in the memory 130 to identify a change in recognition performance of the fingerprint sensor 200.

According to an embodiment, the memory 130 may store instructions that cause the processor 120 to operate when executed. For example, the application may be stored as software (e.g., the program 140 of FIG. 1) in the memory 130, and may be executable by the processor 120. According to an embodiment, the application may include various applications capable of providing various services (e.g., a performance test service for the fingerprint sensor 200) in the electronic device 101. In an embodiment, the performance test service may include a service (or application) for determining whether a change occurs in the recognition performance of the fingerprint sensor 200 due to a protective material and providing the user with feedback according to a determination result. In an embodiment, a performance test may be performed intentionally or unintentionally by the user.

According to an embodiment, the sensor module 260 may correspond to the sensor module 176 described with reference to FIG. 1. According to an embodiment, the sensor module 260 may include various sensors, such as an illuminance sensor 261, an acceleration sensor 263, a gyro sensor 265, and an atmospheric pressure sensor 267. According to an embodiment, the sensor module 260 may include an attitude sensor that may replace the acceleration sensor 263 and/or the gyro sensor 265. According to an embodiment, the electronic device 101 may perform an operation related to a performance test of the fingerprint sensor 200, based on sensor data using the acceleration sensor 263, the gyro sensor 265, and/or the atmospheric pressure sensor 267 of the sensor module 260. For example, the processor 120 may determine a trigger for detecting and configuring a specified environment for the performance test of the fingerprint sensor 200, based on at least one sensor data of the sensor module 260.

According to an embodiment, the processor 120 may perform an application-layer processing function requested by the user of the electronic device 101. According to an embodiment, the processor 120 may provide functional control and a command for various blocks of the electronic device 101. According to an embodiment, the processor 120 may perform an operation or data processing related to control and/or communication of each component of the electronic device 101. For example, the processor 120 may include at least some of the components and/or functions of the processor 120 of FIG. 1. According to an embodiment, the processor 120 may be operatively connected to the components of the electronic device 101. According to an embodiment, the processor 120 may load a command or data received from other components of the electronic device 101 into the memory 130, may process a command or data stored in the memory 130, and may store resulting data.

According to an embodiment, the processor 120 may include processing circuitry and/or an executable program element. According to an embodiment, the processor 120 may control (or process) an operation related to detecting whether a protective material is attached to the display 220, based on the processing circuitry and/or the executable program element. According to an embodiment, the processor 120 may control (or process) an operation related to determining a change in the recognition performance of the fingerprint sensor 200 when the protective material is detected and providing feedback to the user accordingly, based on the processing circuitry and/or the executable program element.

According to an embodiment, the processor 120 may operate to detect a specified trigger related to the performance test of the fingerprint sensor 200 disposed under the display 220. According to an embodiment, the processor 120 may control the fingerprint sensor 200 to obtain a specified image, based on detecting the specified trigger. According to an embodiment, the processor 120 may extract the reference data (e.g., first reference data or second reference data) configured in the memory 130. According to an embodiment, the processor 120 may operate to determine a state related to the protective material attached to the display 220, based on the specified image (e.g., a background image or a fingerprint image) obtained through the fingerprint sensor 200 and the reference data. According to an embodiment, the processor 120 may operate to determine whether there is a change in the performance of the fingerprint sensor 200, based on the state related to the protective material. According to an embodiment, the processor 120 may operate to perform a specified operation, based on whether there is a change in the performance of the fingerprint sensor 200.

According to an embodiment, the processor 120 may control an operation related to performing a first performance test or a second performance test to detect whether there is a change in the performance of the fingerprint sensor 200 due to the protective material.

According to an embodiment, the processor 120 may obtain a background image from a user environment in the first performance test for the fingerprint sensor 200. According to an embodiment, the processor 120 may use a reference background image configured in the manufacturing stage as a comparison image for the background image. According to an embodiment, the processor 120 may perform the first performance test, based on processing (e.g., comparison processing) of the obtained background image and the comparison image (e.g., the reference background image). According to an embodiment, the processor 120 may identify whether the protective material is attached through comparison of the background images respectively obtained from the manufacturing stage and the user environment. According to an embodiment, the processor 120 may infer a characteristic of the protective material (e.g., a protective film or protective glass) according to the difference between the background images and/or the forms of the background images.

According to an embodiment, the processor 120 may obtain a fingerprint image rather than a background image in an environment where fingerprint authentication is performed when performing the second performance test for the fingerprint sensor 200. According to an embodiment, the processor 120 may extract a specific image pattern from the fingerprint image. According to an embodiment, the processor 120 may use numerical data (e.g., a reference map) that is digitized (e.g., binarized/ranged) based on an averaged fingerprint image in the manufacturing stage as a comparison image for the fingerprint image. According to an embodiment, the processor 120 may perform the second performance test, based on processing (e.g., comparison processing) of the image pattern extracted from the obtained fingerprint image and the comparison image (e.g., the reference map). According to an embodiment, the processor 120 may identify a similarity as a numerical value, based on the image pattern extracted by patternizing the fingerprint image and the reference map.

According to an embodiment of the disclosure, the processor 120 may perform the calibration (e.g., the performance test) related to the fingerprint sensor 200 performed in the manufacturing stage of the electronic device 101 at regular intervals or in a specified situation even in an environment where the user uses the electronic device 101, and may provide the result to the user. According to an embodiment, the processor 120 may perform the calibration in a specified environment (e.g., a darkroom environment) that is the same as or similar to that in a process of performing the calibration by using a specified calibration kit (or groove tool) (e.g., a groove tool of a light-absorbing color (e.g., black)) for the calibration of the fingerprint sensor 200. According to an embodiment, the processor 120 may obtain an image (e.g., a background image) in the specified environment, and may compare the image with an image obtained in the calibration of the manufacturing stage of the electronic device 101 (e.g., a background image obtained through the groove tool of the light-absorbing color). According to an embodiment, the processor 120 may detect whether the protective material is attached to the display 220, based on a comparison result. According to an embodiment, when detecting the protective material, the processor 120 may determine the characteristic of the protective material, and may provide related feedback to the user.

According to an embodiment of the disclosure, the processor 120 may perform the calibration (e.g., the performance test) related to the fingerprint sensor 200, based on an image (e.g., a fingerprint image) obtained while the user is using the electronic device 101. According to an embodiment, the processor 120 may obtain the fingerprint image of the user, based on the user's intention or unintention while the user is using the electronic device 101. According to an embodiment, the processor 120 may extract (e.g., binarize or range) a pattern, based on the fingerprint image. According to an embodiment, the processor 120 may compare the extracted pattern with the reference map configured in the electronic device 101. According to an embodiment, the processor 120 may detect whether the protective material is attached to the display 220, based on a comparison result. According to an embodiment, when detecting the protective material, the processor 120 may determine the characteristic of the protective material, and may provide related feedback to the user.

According to an embodiment, the detailed operation of the processor 120 of the electronic device 101 will be described with reference to the following drawings.

According to an embodiment, operations performed by the processor 120 may be implemented in a recording medium (or computer program product). For example, the recording medium may include a non-transitory computer-readable recording medium that records a program to execute various operations performed by the processor 120.

Embodiments described in the disclosure may be implemented in a recording medium readable by a computer or a similar device by using software, hardware, or a combination thereof. According to hardware implementation, operations described in an embodiment may be implemented by using at least one of application-specific integrated circuits (ASICs), digital signal processors (DSPs), digital signal processing devices (DSPDs), programmable logic devices (PLDs), field programmable gate arrays (FPGAs), processors, controllers, micro-controllers, microprocessors, and/or other electrical units for performing functions.

In an embodiment, the recording medium (or computer program product) may include a computer-readable recording medium that records a program to execute an operation of detecting a specified trigger related to a performance test of a fingerprint sensor 200 disposed under a display 220, an operation of controlling the fingerprint sensor 200 to obtain a specified image, based on detecting the specified trigger, an operation of extracting reference data configured in memory 130 of the electronic device 101, an operation of determining a state related to a protective material attachable onto the display 220, based on the specified image obtained through the fingerprint sensor 200 and the reference data, an operation of determining whether performance of the fingerprint sensor 200 is changed, based on the state related to the protective material, and an operation of performing a specified operation, based on whether the performance of the fingerprint sensor 200 is changed.

An electronic device 101 according to an embodiment of the disclosure may include a display (e.g., the display module 160 of FIG. 1 or the display 220 of FIG. 2 or FIG. 6), a fingerprint sensor (e.g., the fingerprint sensor 200 of FIG. 2 or FIG. 6) disposed below the display, memory (e.g., the memory 130 of FIG. 1 or FIG. 6), and a processor (e.g., the processor 120 of FIG. 1 or FIG. 6) operatively connected to the display, the fingerprint sensor, and the memory.

According to an embodiment, the processor 120 may operate to detect a specified trigger related to a performance test of the fingerprint sensor. According to an embodiment, the processor 120 may control the fingerprint sensor to obtain a specified image, based on detecting the specified trigger. According to an embodiment, the processor 120 may operate to extract reference data configured in the memory. According to an embodiment, the processor 120 may operate to determine a state related to a protective material attachable onto the display, based on the specified image obtained through the fingerprint sensor and the reference data. According to an embodiment, the processor 120 may operate to determine whether performance of the fingerprint sensor is changed, based on the state related to the protective material. According to an embodiment, the processor 120 may operate to perform a specified operation, based on whether the performance of the fingerprint sensor is changed.

According to an embodiment, the processor 120 may operate to detect the specified trigger in a first situation based on reception of a user input for the performance test or a second situation based on detection of a specified environment for the performance test.

According to an embodiment, the specified trigger may include a first trigger for performing a first performance test based on a background image obtained in a specified environment. According to an embodiment, the specified trigger may include a second trigger for performing a second performance test based on a fingerprint image obtained in a usage environment of the electronic device.

According to an embodiment, the processor 120 may operate to identify a type of the specified trigger, based on a performance test environment. According to an embodiment, the processor 120 may operate to perform the first performance test by using the background image, based on determining that the specified trigger is the first trigger. According to an embodiment, the processor 120 may operate to perform the second performance test by using the fingerprint image, based on determining that the specified trigger is the second trigger.

According to an embodiment, the processor 120 may operate to obtain the background image through the fingerprint sensor in the specified environment. According to an embodiment, the processor 120 may operate to obtain first reference data configured in the memory. According to an embodiment, the processor 120 may operate to detect whether the protective material is attached, based on comparison between the background image and the first reference data.

According to an embodiment, the first reference data may include at least one reference background image obtained using a specified calibration kit in a calibration of the fingerprint sensor.

According to an embodiment, the processor 120 may operate to obtain a plurality of background images at a specified regular time interval. According to an embodiment, the processor 120 may operate to determine similarity between the plurality of background images.

According to an embodiment, the processor 120 may operate to obtain the background image in a similar environment corresponding to an environment of the calibration of the fingerprint sensor, based on a sensor module of the electronic device.

According to an embodiment, the processor 120 may operate to obtain the fingerprint image through the fingerprint sensor. According to an embodiment, the processor 120 may operate to extract an image pattern, based on the fingerprint image. According to an embodiment, the processor 120 may operate to obtain second reference data configured in the memory. According to an embodiment, the processor 120 may operate to detect whether the protective material is attached, based on comparison between the image pattern and the second reference data.

According to an embodiment, the second reference data may include at least one reference map obtained by digitizing an image pattern extracted based on an averaged fingerprint image in a calibration of the fingerprint sensor.

According to an embodiment, the processor 120 may operate to extract the image pattern by digitizing an image area in a range corresponding to the reference map in the fingerprint image.

According to an embodiment, the processor 120 may operate to calculate similarity between the image pattern and the second reference data. According to an embodiment, the processor 120 may operate to compare the calculated similarity with a specified threshold value. According to an embodiment, the processor 120 may operate to determine that there is the protective material on the display when the similarity is the specified threshold value or greater.

According to an embodiment, the processor 120 may operate to determine whether there is the protective material on the display, based on the specified image and the reference data. According to an embodiment, the processor 120 may operate to analyze a characteristic of the protective material when determining that there is the protective material. According to an embodiment, the processor 120 may operate to determine whether the performance of the fingerprint sensor is changed, based on the characteristic of the protective material.

According to an embodiment, the processor 120 may operate to determine a first specified state in which the performance of the fingerprint sensor is not changed when determining that there is no protective material. According to an embodiment, the processor 120 may operate to determine a second specified state in which the performance of the fingerprint sensor is not changed or a third specified state in which the performance of the fingerprint sensor is changed, based on the characteristic of the protective material when determining that there is the protective material. According to an embodiment, the processor 120 may operate to provide a specified guide related to the protective material corresponding to the determined specified state.

Hereinafter, an operating method of an electronic device 101 according to various embodiments will be described in detail. Operations performed by the electronic device 101 according to various embodiments may be executed by a processor 120 of the electronic device 101 including various processing circuits and/or executable program elements. According to an embodiment, the operations performed by the electronic device 101 may be executed by instructions that are stored in memory 130 and cause the processor 120 to operate when executed.

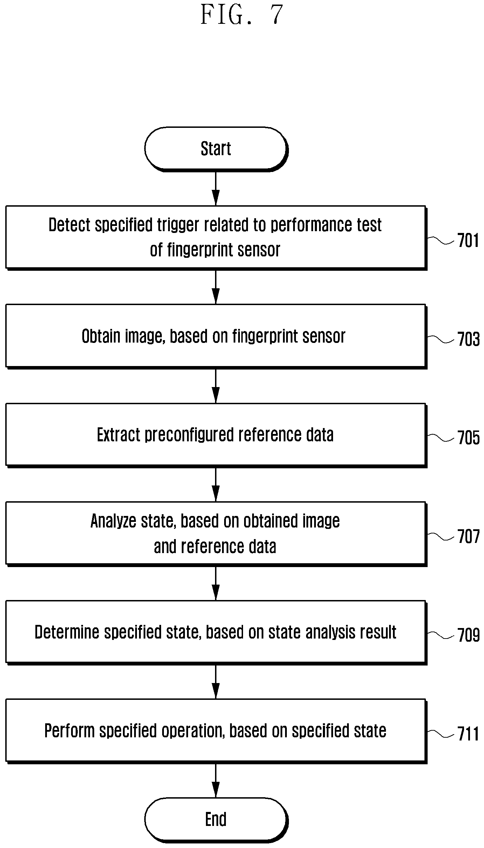

FIG. 7 is a flowchart illustrating an operating method of an electronic device according to an embodiment of the disclosure.

According to an embodiment, FIG. 7 may illustrate an example in which an electronic device 101 supports a performance test for the recognition performance of a fingerprint sensor 200 according to an embodiment.

A method in which the electronic device 101 supports the performance test of the fingerprint sensor 200 according to an embodiment of the disclosure may be performed, for example, according to the flowchart illustrated in FIG. 7. The flowchart illustrated in FIG. 7 is merely a flowchart illustrating a performance text method of the electronic device 101 according to an embodiment, in which at least some operations may be performed in a different order, in parallel, or independently, or at least some other operations may be performed complementarily to the at least operations. According to an embodiment of the disclosure, operation 701 to operation 711 may be performed by at least one processor 120 of the electronic device 101.

As illustrated in FIG. 7, the operating method performed by the electronic device 101 according to an embodiment may include an operation 701 of detecting a specified trigger related to the performance test of the fingerprint sensor 200, an operation 703 of obtaining an image, based on the fingerprint sensor 200, an operation 705 of extracting configured reference data, an operation 707 of analyzing a state related to a protective material attachable to a display 220, based on the obtained image and the reference data, an operation 709 of determining a state, based on a result of analyzing the state, and an operation 711 of performing a specified operation, based on the state.

Referring to FIG. 7, in operation 701, the processor 120 of the electronic device 101 may detect a specified trigger related to a performance test of the fingerprint sensor 200. According to an embodiment, the processor 120 may detect the specified trigger, based on a first situation (e.g., a user-intended situation) in which an input for a user to explicitly request the performance test of the fingerprint sensor 200 (e.g., to request execution of a performance test service (or application)) is received or a second situation (e.g., a user-unintended situation) in which a specified environment (or condition) is detected for the performance test of the fingerprint sensor 200. For example, the first situation may include a case in which the electronic device 101 passively performs the performance test by the user. For example, the second situation may include a case in which the electronic device 101 automatically performs the performance test.

In an embodiment, the specified trigger may include a first trigger and a second trigger that is different from the first trigger. In an embodiment, the first trigger may refer to a trigger for performing a first performance test based on a background image obtained in a specified environment (e.g., a darkroom environment). In an embodiment, the second trigger may refer to a trigger for performing a second performance test based on a fingerprint image obtained in a usage environment of the electronic device 101.

In operation 703, the processor 120 may obtain an image, based on the fingerprint sensor 200. According to an embodiment, the processor 120 may control the fingerprint sensor 200 to obtain a specified image. In an embodiment, the processor 120 may control the fingerprint sensor 200 to obtain a background image or a fingerprint image corresponding to the specified trigger. For example, the fingerprint sensor 200 may perform a photographing operation to obtain the background image or the fingerprint image, based on control of the processor 120.

In an embodiment, the background image may refer to an image obtained from a groove tool of an absorbing color or an environment corresponding thereto. In an embodiment, the fingerprint image may refer to an image obtained through the fingerprint sensor 200 while the user uses the electronic device 101 (e.g., during a fingerprint authentication operation). In an embodiment, the obtained image (e.g., the background image and/or the fingerprint image) may be characteristically distinguished according to a retarding characteristic of a protective material, and may be used to determine thickness information about the protective material and/or signal characteristic information about the image.

In operation 705, the processor 120 may extract configured reference data. According to an embodiment, the processor 120 may obtain reference data related to the specified image from a specified storage area (e.g., memory 130 or memory of the fingerprint sensor 200). According to an embodiment, when the specified trigger is the first trigger related to the first performance test based on the background image, the processor 120 may extract first reference data related to the background image obtained according to the first trigger. According to an embodiment, when the specified trigger is the second trigger related to the second performance test based on the fingerprint image, the processor 120 may extract second reference data related to the fingerprint image obtained according to the second trigger.

In an embodiment, the first reference data may refer to reference data for image comparison in the first performance test. In an embodiment, the first reference data may include at least one background image obtained in a specified environment during a calibration of the fingerprint sensor 200. In an embodiment, the second reference data may refer to reference data for image comparison in the second performance test. In an embodiment, the second reference data may include at least one reference map based on an image pattern extracted through a specified calculation in the calibration of the fingerprint sensor 200. In an embodiment, the first reference data and the second reference data may be stored (or configured) in the memory 130 during the calibration.

In operation 707, the processor 120 may analyze a state (e.g., information related to whether the protective material is attached and/or a characteristic of the protective material) related to a protective material attachable onto the display 220, based on the obtained image and the reference data. According to an embodiment, the processor 120 may compare the obtained image (e.g., the background image or the fingerprint image) with corresponding reference data. For example, the processor 120 may compare the obtained background image with the first reference data.

For example, the processor 120 may compare the obtained fingerprint image with the second reference data. According to an embodiment, the processor 120 may analyze a first state relating to whether the protective material is attached to the display 220, based on a comparison result (e.g., similarity between the obtained image and the reference data). According to an embodiment, when detecting that the protective material is attached, the processor 120 may analyze a second state relating to a change in the performance due to the protective material, based on an analysis of the characteristic of the protective material.

In operation 709, the processor 120 may determine a specified state related to a change in the performance of the fingerprint sensor 200, based on a state analysis result. According to an embodiment, the processor 120 may determine the specified state related to the change in the performance of the fingerprint sensor 200 based on the result of analyzing the first state and the second state. According to an embodiment, the processor 120 may determine the specified state, based on whether the protective material is detected and the analysis of the characteristic of the protective material when the protective material is detected.

In an embodiment, the specified state may include a first specified state, a second specified state, or a third specified state. In an embodiment, the first specified state may refer to a state in which no protective material is attached (e.g., a state in which the performance of the fingerprint sensor 200 is not affected). In an embodiment, the second specified state may refer to a state in which the protective material is attached but does not substantially affect the performance of the fingerprint sensor 200. In an embodiment, the third specified state may refer to a state in which the protective material is attached and affects the performance of the fingerprint sensor 200.

In operation 711, the processor 120 may perform a specified operation, based on the specified state. According to an embodiment, the processor 120 may provide the user with a specified guide related to the specified state by using visual, auditory, and/or tactile information. According to an embodiment, the processor 120 may operate to provide a first specified guide based on the first specified state, provide a second specified guide based on the second specified state, or provide a third specified guide based on the third specified state.

According to an embodiment, the processor 120 may provide a notification that there is no protective material or that there is no problem with use of the fingerprint sensor 200 in response to determining the first specified state or the second specified state. According to an embodiment, when the performance test is a test automatically performed by the electronic device 101 as in the second situation, the notification may not be provided in the first specified state or the second specified state.

According to an embodiment, the processor 120 may induce removal or replacement of the protective material, based on a guide on a phenomenon of interaction between the protective material and the fingerprint sensor 200 (e.g., an explanation from the perspective of the fingerprint sensor 200) and/or a guide on a phenomenon of the protective material itself (e.g., an explanation from the perspective of the protective material), in response to determining the third specified state. In an embodiment, the guide from the perspective of the fingerprint sensor 200 may include a guide, for example, "The protective material is not suitable for use with the fingerprint sensor." or "Non-genuine protective materials may degrade the performance of the fingerprint sensor." In an embodiment, the guide from the perspective of the protective material may include a guide, for example, "A non-genuine display protective material is being used."

According to an embodiment, the processor 120 may provide the user with a guide to induce replacement of the protective material in response to determining the third specified state. In an embodiment, the guide to induce the replacement of the protective material may include a guide, for example, "Please replace the attached protective material if the performance of the fingerprint sensor is degraded," "Please visit a service center if the performance of the fingerprint sensor is degraded," and/or "Using a genuine protective material may improve the performance of the fingerprint sensor."

According to an embodiment, the processor 120 may store the image (e.g., the background image or the fingerprint image) obtained during the performance test in the memory 130. According to an embodiment, the stored image may be used, for example, as fingerprint performance analysis data about the user who visits a service center. According to an embodiment, the processor 120 may use the stored image for image processing used for fingerprint authentication by the fingerprint sensor 200.

According to an embodiment, the processor 120 may provide a tuning parameter for a touch sensor, a proximity sensor, and/or an illuminance sensor that may be affected by the protective material, based on the characteristic of the protective material.

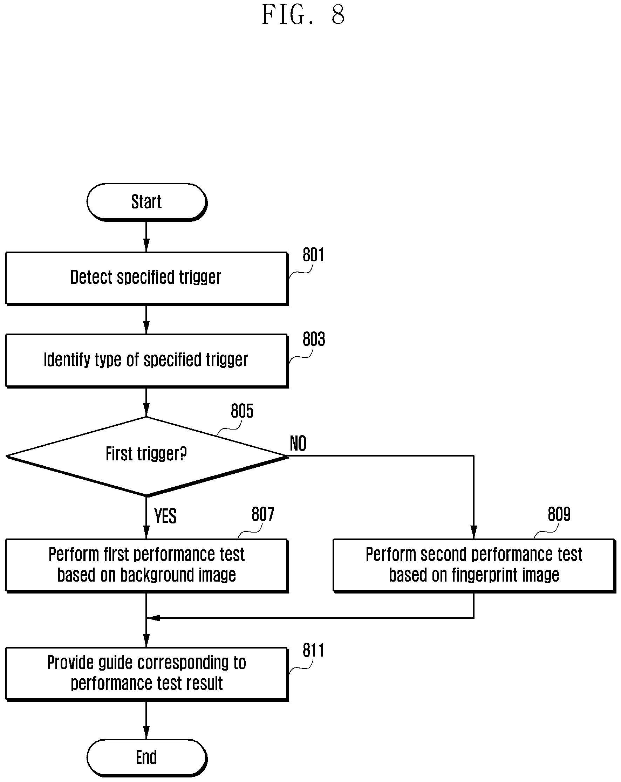

FIG. 8 is a flowchart illustrating an operating method of an electronic device according to an embodiment of the disclosure.

According to an embodiment, FIG. 8 may illustrate an example in which an electronic device 101 supports a performance test for the recognition performance of a fingerprint sensor 200 according to an embodiment. According to an embodiment, FIG. 8 may illustrate an example of determining and operating a first performance test or a second performance test based on the type of a specified trigger. According to an embodiment, operations illustrated in FIG. 8 may be performed heuristically, for example, in combination with the operations illustrated in FIG. 7, or may be performed heuristically as detailed operations of at least some of the illustrated operations.

A method in which the electronic device 101 supports the performance test of the fingerprint sensor 200 according to an embodiment of the disclosure may be performed, for example, according to the flowchart illustrated in FIG. 8. The flowchart illustrated in FIG. 8 is merely a flowchart illustrating a performance text method of the electronic device 101 according to an embodiment, in which at least some operations may be performed in a different order, in parallel, or independently, or at least some other operations may be performed complementarily to the at least operations. According to an embodiment of the disclosure, operation 801 to operation 811 may be performed by at least one processor 120 of the electronic device 101.

As illustrated in FIG. 8, the operating method performed by the electronic device 101 according to an embodiment may include an operation 801 of detecting a specified trigger, an operation 803 of identifying the type of the specified trigger, an operation 805 of determining whether the specified trigger is a first trigger or a second trigger, an operation 807 of performing a first performance test based on a background image, based on determining the first trigger, an operation 809 of performing a second performance test based on a fingerprint image, based on determining the second trigger, and an operation 811 of providing a guide corresponding to a result of a performance test (e.g., the first performance test or the second performance test).

Referring to FIG. 8, in operation 801, the processor 120 of the electronic device 101 may detect a specified trigger related to a performance test of the fingerprint sensor 200. According to an embodiment, the processor 120 may detect the specified trigger, based on a user-intended situation (e.g., a first situation based on reception of a user input for the performance test) or a user-unintended situation (e.g., a second situation based on detection of a specified environment for the performance test).

In operation 803, the processor 120 may identify the type of the specified trigger. According to an embodiment, the specified trigger may include a first trigger and a second trigger. In an embodiment, the first trigger may refer to a trigger for performing a first performance test based on a background image obtained in a specified environment (e.g., a darkroom environment). In an embodiment, the second trigger may refer to a trigger for performing a second performance test based on a fingerprint image obtained in a usage environment of the electronic device 101.

According to an embodiment, the processor 120 may determine the usage environment of the electronic device 101 through context awareness based on at least one sensor data of the sensor module 260. In an embodiment, the processor 120 may identify the type of the specified trigger, based on a first performance test environment, such as a darkroom environment, a state in which the electronic device 101 is not in operation, and/or a user's request to execute the first performance test, or a second performance test environment, such as a state in which the fingerprint sensor 200 is in operation while the electronic device 101 is in use, a state in which a fingerprint image is obtainable by the fingerprint sensor 200, and/or a user's request to execute the second performance test.

In operation 805, the processor 120 may determine whether the specified trigger is a first trigger or a second trigger. According to an embodiment, the processor 120 may determine the first trigger, based on a result of context awareness related to the first performance test environment. According to an embodiment, the processor 120 may determine the second trigger, based on a result of context awareness related to the second performance test environment.

In operation 807, the processor 120 may perform the first performance test based on the background image, based on determining the first trigger. According to an embodiment, the processor 120 may obtain a background image, and may perform the first performance test, based on a comparative analysis between the obtained background image and configured first reference data (e.g., a reference background image). An operation of performing the first performance test according to an embodiment is described with reference to a drawing to be described below.

In operation 809, the processor 120 may perform the second performance test based on the fingerprint image, based on determining the second trigger. According to an embodiment, the processor 120 may obtain a fingerprint image, and may perform the second performance test, based on a comparative analysis between the obtained fingerprint image and set second reference data (e.g., a reference map). An operation of performing the second performance test according to an embodiment is described with reference to a drawing to be described below.

In operation 811, the processor 120 may provide a guide corresponding to a performance test result. According to an embodiment, the processor 120 may provide various guides on the performance test result as described with reference to operation 711 of FIG. 7.

According to an embodiment of the disclosure, the electronic device 101 may detect a protective material, based on an image (e.g., a background image) obtained in an environment similar to an environment for a calibration in a manufacturing stage, such as in control of an external light source that is introduced from the outside and acts as noise, and may determine whether the recognition performance of the fingerprint sensor 200 changes due to the protective material. For example, the electronic device 101 may perform a performance test (e.g., a first performance test of FIG. 8) for the fingerprint sensor 200 by using an image (e.g., a background image) obtained in a specified environment, such as a darkroom environment. Hereinafter, an example of a method for performing the first performance test based on the background image will be described.

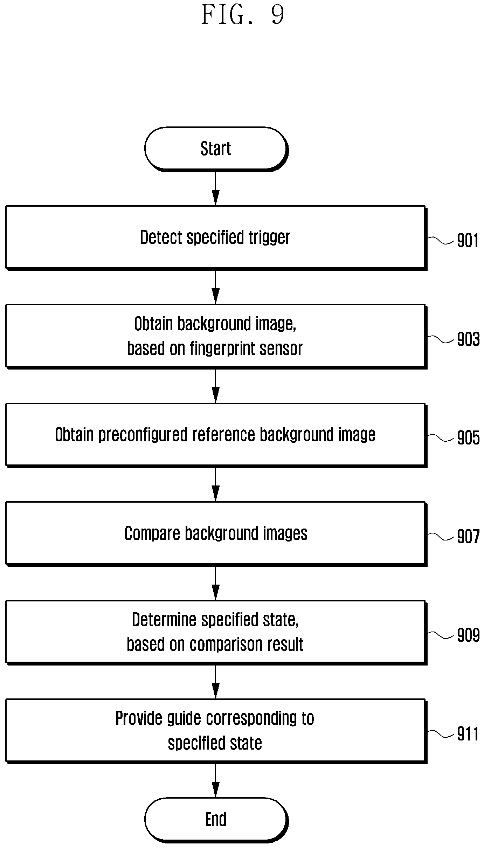

FIG. 9 is a flowchart illustrating an operating method of an electronic device according to an embodiment of the disclosure.

According to an embodiment, FIG. 9 may illustrate an example in which an electronic device 101 supports a performance test for the recognition performance of a fingerprint sensor 200 according to an embodiment. According to an embodiment, FIG. 9 may illustrate an example of an operation of performing a first performance test based on a background image. According to an embodiment, operations illustrated in FIG. 9 may be performed heuristically, for example, in combination with the operations illustrated in FIG. 7 and FIG. 8, or may be performed heuristically as detailed operations of at least some of the illustrated operations.

A method in which the electronic device 101 supports the performance test of the fingerprint sensor 200 according to an embodiment of the disclosure may be performed, for example, according to the flowchart illustrated in FIG. 9. The flowchart illustrated in FIG. 9 is merely a flowchart illustrating a performance text method of the electronic device 101 according to an embodiment, in which at least some operations may be performed in a different order, in parallel, or independently, or at least some other operations may be performed complementarily to the at least operations. According to an embodiment of the disclosure, operation 901 to operation 911 may be performed by at least one processor 120 of the electronic device 101.

As illustrated in FIG. 9, the operating method performed by the electronic device 101 according to an embodiment may include an operation 901 of detecting a specified trigger, an operation 903 of obtaining a background image, based on the fingerprint sensor 200, an operation 905 of obtaining a configured reference background image, an operation 907 of comparing the background images, an operation 909 of determining a specified state, based on a comparison result, and an operation 911 of providing a guide corresponding to the specified state.

Referring to FIG. 9, in operation 901, the processor 120 of the electronic device 101 may detect a specified trigger (e.g., a first specified trigger). According to an embodiment, the processor 120 may detect the first specified trigger, based on a first situation (e.g., a user-intended situation) in which an input for a user to explicitly request the performance test of the fingerprint sensor 200 (e.g., to request execution of a performance test service (or application)) is received or a second situation (e.g., a user-unintended situation) in which a specified environment (or condition) for the performance test of the fingerprint sensor 200 is detected.

According to an embodiment, a first performance test for the fingerprint sensor 200 may be performed under a condition in which an environment the same as or similar to a calibration kit (e.g., an absorbing-color groove tool, which is black) used in the manufacturing stage of the electronic device 101 is maintained. For example, a specified environment for the first performance test may be an environment in which ambient external light is in a certain level or lower (e.g., a condition in which the electronic device 101 exists in a dark environment, such as a darkroom).

According to an embodiment, when detecting the first specified trigger based on the first situation (user-intended situation), the processor 120 may guide a user to identify an ambient external light condition and configure a corresponding environment (e.g., a darkroom environment) by using a sensor module 260 (e.g., an illuminance sensor 261) in the first situation.

According to an embodiment, the processor 120 may periodically monitor a specified condition (e.g., the ambient external light condition, a condition in which the electronic device 101 is not moving, a condition in which the electronic device 101 is not operating and is in an inactive state (e.g., a sleep mode), a condition in which a display 220 is off, and/or a condition in which a calibration kit used in the manufacturing stage of the electronic device 101 or a similar calibration kit is used) by using the sensor module 260 (e.g., the illuminance sensor 261, an acceleration sensor 263, or a gyro sensor 265), and may detect the first specified trigger based on the first situation when detecting the specified condition.

According to an embodiment, the first situation (e.g., the user-intended situation) may include various situations, such as a case where the user starts a process of registering (or re-registering) a fingerprint by using the electronic device 101, a case where fingerprint recognition performance data (e.g., the number of recognition failures) accumulated in the electronic device 101 exceeds a specified level, and/or a case where the user directly selects a fingerprint recognition performance test item generated on a menu. According to an embodiment, when detecting the first situation, the processor 120 may guide the user to install a screen in the area of the fingerprint sensor 200 to minimize ambient light, or to conduct the performance test in a darkroom environment, such as in a dark night.

According to an embodiment, the processor 120 may measure the illuminance of a surrounding environment by using the sensor module 260 and/or a camera module 270 according to a user input with respect to a guide, and may determine a second specified condition by using the sensor module 260 in an illuminance environment of a certain level or lower (e.g., a first specified condition). **In** an embodiment, the second specified condition may include the condition in which the electronic device 101 is not operating and is in the inactive state, the condition in which the electronic device 101 is not moving, the condition in which the display 220 is off, and/or the condition in which the calibration kit used in the manufacturing stage of the electronic device 101 or the similar calibration kit is used.

According to an embodiment, the second situation (e.g., the user-unintended situation) may be, for example, a case where the electronic device 101 is in a darkroom condition, for example, a situation where there is no sunlight or indoor/outdoor lighting. According to an embodiment, the processor 120 may determine the first specified condition by using the sensor module 260. According to an embodiment, the processor 120 may determine a third specified condition by using the sensor module 260 in the first specified condition. In an embodiment, the third specified condition may include the condition in which the electronic device 101 is not operating and is in the inactive state, the condition in which the electronic device 101 is not moving, a condition in which the electronic device 101 is being charged, the condition in which the display is off, a condition in which the electronic device 101 is repeatedly placed back in a location (e.g., home) a specific number of times and/or at a certain time (e.g., a condition in which the electronic device is repeatedly placed in a location, such as the user's home, every day), and/or a condition in which a specific time elapses after the user has sufficiently entered a sleep state in conjunction with a sleep function of an application (e.g., a healthcare application) installed in the electronic device 101.

In an embodiment, the second specified condition and the third specified condition may be configured to be the same or different.

In operation 903, the processor 120 may obtain a background image, based on the fingerprint sensor 200. According to an embodiment, the processor 120 may detect the first specified trigger, based on the first situation or the second situation, and may control the fingerprint sensor 200 to capture a background image, based on detecting the first designated trigger. According to an embodiment, the fingerprint sensor 200 may capture at least one background image, based on control of the processor 120. According to an embodiment, the processor 120 may obtain at least one background image from the fingerprint sensor 200.

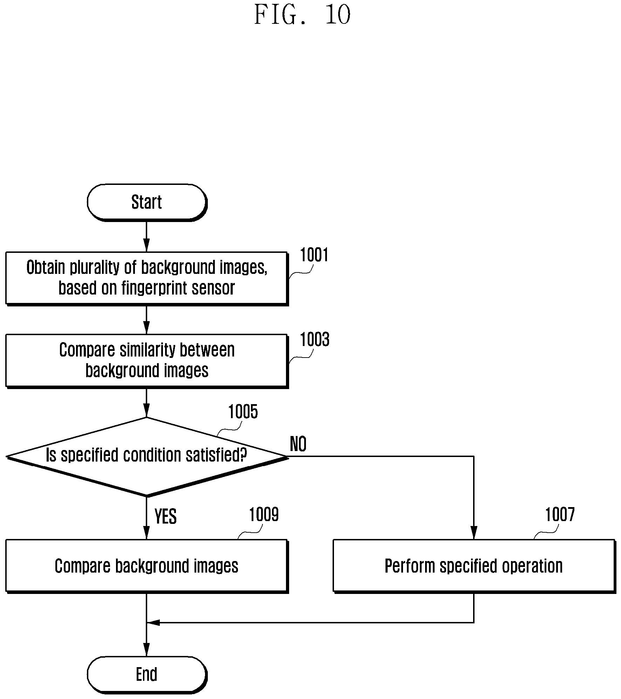

According to an embodiment, the processor 120 may obtain a specified number of background images after the environment the same as/similar to the environment in which the calibration kit (e.g., an absorbing groove tool) is used in a calibration performed in the manufacturing stage of the electronic device 101 is configured. According to an embodiment, the processor 120 may control the operation of the fingerprint sensor 200 to obtain a plurality of background images at specified time intervals. An operation of obtaining the background images according to an embodiment is described below with reference to FIG. 10.

In operation 905, the processor 120 may obtain a configured reference background image. According to an embodiment, the reference background image may include a background image obtained using a calibration kit (e.g., an absorbing-color groove tool (e.g., black)) specified according to the calibration in the manufacturing stage of the electronic device 101. In an embodiment, the reference background image may be configured (or stored) in memory 130 in the manufacturing stage. According to an embodiment, the processor 120 may extract the reference background image (e.g., first reference data) among various configured reference data from the memory 130 in response to detection of the first trigger related to the first performance test.

In operation 907, the processor 120 may compare the background images. According to an embodiment, the processor 120 may compare and analyze the obtained background image and the reference background image of the calibration. An operation of comparing and analyzing the background images according to an embodiment is described with reference to a drawing to be described below.

In operation 909, the processor 120 may determine a specified state, based on a comparison result. According to an embodiment, the specified state may include a state in which no protective material is attached (e.g., a first specified state in which the performance of the fingerprint sensor 200 is not affected), a state in which a protective material is attached but does not affect the performance of the fingerprint sensor 200 (e.g., a second specified state), and/or a state in which the protective material is attached and affects the performance of the fingerprint sensor 200 (e.g., a third specified state). According to an embodiment, the processor 120 may determine the specified state, based on whether the protective material is detected and an analysis of a characteristic of the protective material when the protective material is detected. An operation of determining the specified state according to an embodiment is described with reference to a drawing to be described below.

In operation 911, the processor 120 may provide a guide corresponding to the specified state. According to an embodiment, the processor 120 may provide various guides on a performance test result as described with reference to operation 711 of FIG. 7.

FIG. 10 is a flowchart illustrating an operating method of an electronic device according to an embodiment of the disclosure.

According to an embodiment, FIG. 10 may illustrate an example in which an electronic device 101 supports a performance test for the recognition performance of a fingerprint sensor 200 according to an embodiment. According to an embodiment, FIG. 10 may illustrate an example of an operation of obtaining a background image in a first performance test. According to an embodiment, operations illustrated in FIG. 10 may be performed heuristically, for example, in combination with the operations illustrated in FIG. 7 to FIG. 9, or may be performed heuristically as detailed operations of at least some of the illustrated operations.

A method in which the electronic device 101 supports the performance test of the fingerprint sensor 200 according to an embodiment of the disclosure may be performed, for example, according to the flowchart illustrated in FIG. 10. The flowchart illustrated in FIG. 10 is merely a flowchart illustrating a performance text method of the electronic device 101 according to an embodiment, in which at least some operations may be performed in a different order, in parallel, or independently, or at least some other operations may be performed complementarily to the at least operations. According to an embodiment of the disclosure, operation 1001 to operation 1009 may be performed by at least one processor 120 of the electronic device 101.

As illustrated in FIG. 10, the operating method performed by the electronic device 101 according to an embodiment may include an operation 1001 of obtaining a plurality of background images, based on the fingerprint sensor 200, an operation 1003 of comparing similarity between background images, an operation 1005 of determining whether the similarity between the background images satisfy a specified condition, an operation 1007 of performing a specified operation when the similarity between the background images does not satisfy the specified condition, and an operation 1009 of comparing the background images when the similarity between the background images satisfies the specified condition.

Referring to FIG. 10, in operation 1001, the processor 120 of the electronic device 101 may obtain a plurality of background images, based on the fingerprint sensor 200. According to an embodiment, the processor 120 may control the operation of the fingerprint sensor 200 to obtain a background image at a specified time interval. According to an embodiment, the fingerprint sensor 200 may operate to capture a background image at the specified time interval, based on control of the processor 120.

In operation 1003, the processor 120 may compare similarity between background images. According to an embodiment, the processor 120 may determine whether there is a change (e.g., a difference) between the plurality of background images. For example, the processor 120 may determine whether there is the change, based at least on the shape, brightness, noise, and/or foreign matter shape of the background images.

In operation 1005, the processor 120 may determine whether the similarity between the background images satisfies a specified condition. According to an embodiment, the processor 120 may determine whether there is a change of a specified level or greater between the plurality of background images. According to an embodiment, the processor 120 may determine that the specified condition is not satisfied when there is a change of the specified level or greater. According to an embodiment, the processor 120 may determine that the specified condition is satisfied when there is a change less than the specified level or when there is no change.

When the similarity between the background images does not satisfy the specified condition in operation 1005 (e.g., No in operation 1005), the processor 120 may perform a specified operation in operation 1007. According to an embodiment, the processor 120 may compare the plurality of background images, and may stop the performance test or return to the initial operation (e.g., operation 1001) when a change between the background images is identified in at least one of the shape, brightness, noise, and/or foreign matter shape.

When the similarity between the background images satisfies the specified condition in operation 1005 (e.g., Yes in operation 1005), the processor 120 may compare the background images in operation 1009. According to an embodiment, the processor 120 may perform an operation of comparing and analyzing an obtained background images with a configured reference background image.

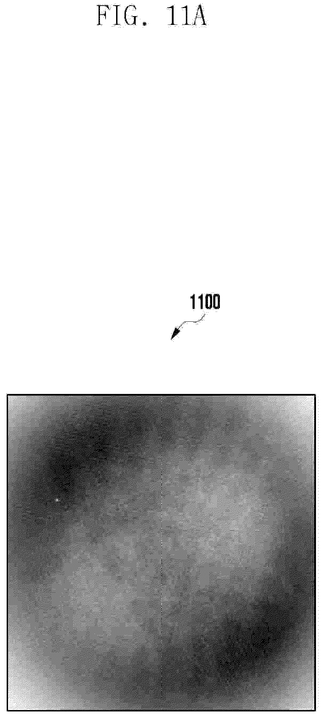

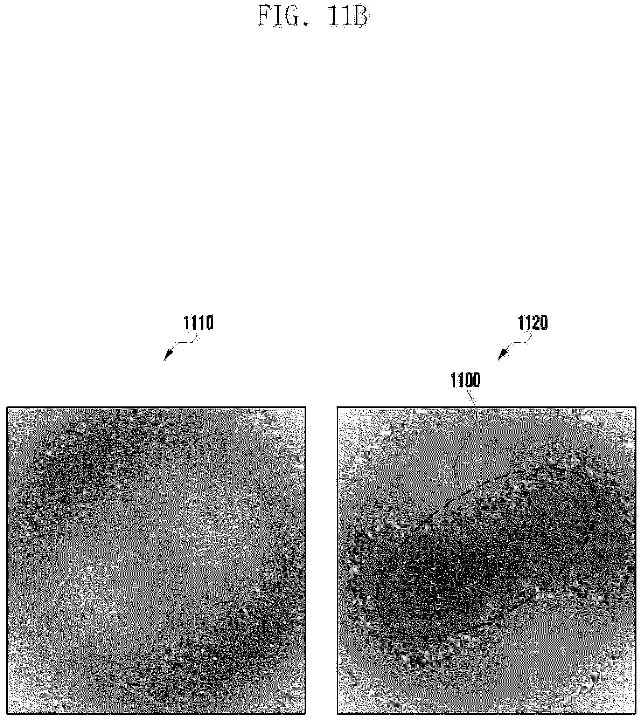

FIG. 11A and FIG. 11B are reference views illustrating an example in which an electronic device detects a protective material by using a background image according to an embodiment of the disclosure.

According to an embodiment, FIG. 11A and FIG. 11B may illustrate an example of a comparative analysis operation of a background image based on a background image obtained through a fingerprint sensor 200 and a reference background image (or reference data) configured in a calibration of the fingerprint sensor 200. According to an embodiment, FIG. 11A and FIG. 11B may illustrate an example of an operation of detecting whether a protective material is attached to a display 220 by using a background image in the comparative analysis operation.

According to an embodiment, FIG. 11A may illustrate an example of a reference background image 1100 configured in the calibration of the fingerprint sensor 200. According to an embodiment, FIG. 11B may illustrate an example of a background image (e.g., a first background image 1110 or a second background image 1120) captured through the fingerprint sensor 200 in a first performance test. According to an embodiment, the first background image 1110 in FIG. 11B may be an example of a background image captured by the fingerprint sensor 200 in the absence of a protective material (e.g., in a state in which no protective material is attached to the display 220). According to an embodiment, the second background image 1120 in FIG. 11B may be an example of a background image captured by the fingerprint sensor 200 in the presence of a protective material (e.g., in a state in which the protective material is attached to the display 220).

As illustrated in FIG. 11A and FIG. 11B, the first background image 1110 in the absence of the protective material is identified as being the same as or similar to the reference background image 1100. As illustrated in FIG. 11A and FIG. 11B, the second background image 1120 in the presence of the protective material is identified as differing from the reference background image 1100.

According to an embodiment, when the retarding direction of the protective material is different from the direction of a polarizer 330 in the display 220 of the electronic device 101, a change may occur in a background image obtained from an absorbing-color groove tool (e.g., black). For example, the intensity of a signal (e.g., the amount of light) received in a specific direction may change, and thus a characteristic of an output background image may change. For example, a difference may occur between the reference background image 1100 in the calibration and the second background image 1120 captured in the presence of the protective material, and thus the processor 120 may detect whether the protective material is attached, based on the difference between the background images.

According to an embodiment, when a light source passing through the protective material having a retarding characteristic passes back through the polarizer 330 of the display 220, a change in an image may occur due to signal loss in a specific direction. The change in the image may be determined based on various methods, for example, a white ratio, a pattern shape, the number of patterns, a pattern position, a major/minor axis angle, and/or a major/minor axis ratio. For example, due to retarding and the angle of the polarizer 330, diagonal dark stripes 1100 may occur as in the example of the second background image 1120 when the protective material is attached.

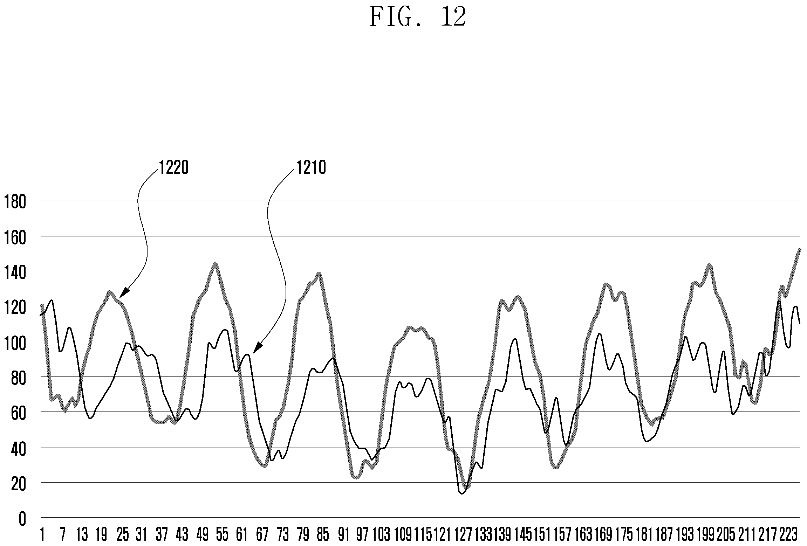

FIG. 12 is a reference view illustrating an example of a signal characteristic of a fingerprint sensor according to the presence or absence of a protective material in an electronic device according to an embodiment of the disclosure.

According to an embodiment, FIG. 12 may be a graph showing a signal characteristic change of the fingerprint sensor 200 depending on whether a protective material is attached to a display 220. According to an embodiment, a first graph 1210 may show a signal characteristic change of the fingerprint sensor 200 in a state in which the protective material is attached. According to an embodiment, a second graph 1220 may show a signal characteristic change of the fingerprint sensor 200 in a state in which no protective material is attached.

According to an embodiment, the performance of the fingerprint sensor 200 may be related to the signal characteristic of the fingerprint sensor 200. For example, the signal characteristic may be obtained by a groove tool having a specific pattern (e.g., apricot color) in a calibration of the fingerprint sensor 200, and may be digitized based on how properly white and black patterns on an image are distinguished. For example, the signal characteristic may be such that the white/black boundary is distinct when there is no protective material. For example, in the presence of the protective material, the signal characteristic may become dark in a valley that is a position where light is reflected in an external object (e.g., the groove tool having the specific pattern (e.g., apricot color) or a fingerprint), and the white/black boundary may be relatively blurred. For example, the protective material may act as a factor that deteriorates the image quality of the fingerprint sensor 200. According to an embodiment, the signal characteristic of the image may be profiled as illustrated in the example of FIG. 12.

As illustrated in FIG. 12, the signal characteristic is identified as being deteriorated in the state in which the protective material is attached. According to an embodiment, the reason why the signal characteristic is deteriorated may be that the specific retarding direction of the protective material and the polarization direction of the display 220 do not match, or the protective material is thick, causing the focal length of the fingerprint sensor 200 to change.

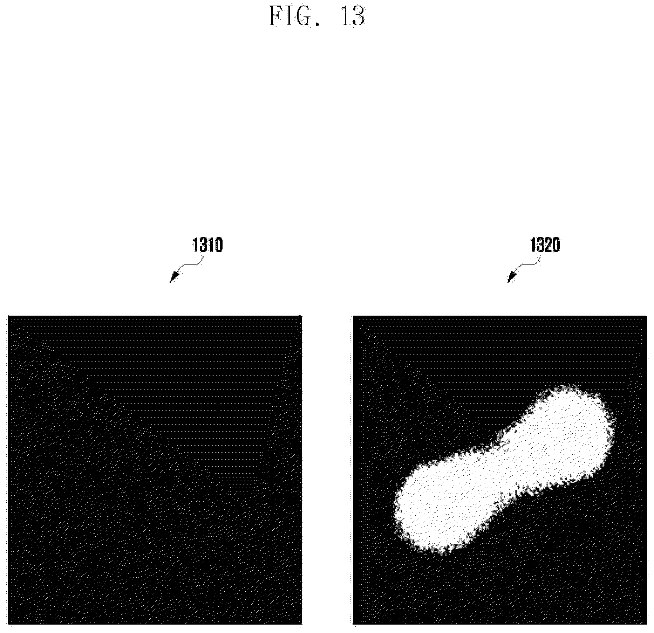

FIG. 13 is a reference view illustrating an example of an image processing result of an image obtained through a fingerprint sensor in an electronic device according to an embodiment of the disclosure.

According to an embodiment, FIG. 13 may illustrate an example of a result (e.g., a first result 1310 or a second result 1320) of obtaining the difference between an image (e.g., the reference background image 1100 of FIG. 11A) obtained in a calibration and each image (e.g., the first background image 1110 and the second background image 1120 of FIG. 11B) obtained according to whether a protective material is attached and performing image processing on the difference.

According to an embodiment, the first result 1310 may be an example of a result of obtaining the difference between the reference background image 1100 and the first background image 1110 in a state in which no protective material is attached and performing image processing thereon. According to an embodiment, the second result 1320 may be an example of a result of obtaining the difference between the reference background image 1100 and the second background image 1120 in a state in which the protective material is attached and performing image processing thereon.

According to an embodiment, the processor 120 may obtain no pattern or a pattern having a specific shape through image processing on an image. According to an embodiment, the pattern having the specific shape may be in various shapes depending on an image processing method. For example, when comparing the reference background image 1100 and the second background image 1120, a specific pattern (e.g., a peanut shape) may be extracted as in the second result 1320.

According to an embodiment, the image (e.g., the first background image 1110) obtained in the state in which no protective material is attached may be the same as the image (e.g., the reference background image 1100) obtained in the calibration, and when image processing for obtaining the difference between the images is performed, the entire image may be expressed in a single color (e.g., black) and may have no pattern as illustrated in the first result 1310 of FIG. 13.

According to an embodiment, the image (e.g., the second background image 1120) obtained in the state in which the protective material is attached may be the different from the image (e.g., the reference background image 1100) obtained in the calibration, and when image processing for obtaining the difference between the images is performed, the specific pattern (e.g., the peanut shape) may be shown as illustrated in the second result 1320 of FIG. 13. For example, the first result 1310 and the second result 1320 of FIG. 13 may be results due to the angle between the retarding direction of the protective material and the polarization direction of a polarizer 330 of a display 220 and a characteristic (e.g., thickness characteristics) of the protective material.

According to an embodiment, the processor 120 may detect whether the protective material is attached, based on the pattern illustrated in FIG. 13. In an embodiment, various methods may be used to detect whether the protective material is attached. According to an embodiment, the processor 120 may detect whether the protective material is attached, based at least on the ratio of a specific color (e.g., white or pixel value), the shape of the specific pattern, the angle of the major axis or the minor axis of the specific pattern, the ratio between the minor axis and the major axis of the specific pattern, the number of specific patterns, and/or the position of the specific pattern. In an embodiment, the specific pattern may refer to an image pattern including a characteristic in which the retarding characteristic of the protective material and a characteristic of the polarizer 330 in the display 220 are combined.

According to an embodiment, the processor 120 may determine various states by using an image resulting from the image processing (hereinafter, "processed image"). According to an embodiment, when the processed image is monochrome (e.g., entirely black like the first result 1310), the signal quality of the fingerprint sensor 200 is not affected, and thus the processor 120 may determine that the protective material is not attached or does not affect the recognition performance of the fingerprint sensor 200 even when attached. For example, when the retarding direction and the direction of the polarizer match, signal loss does not occur and SNR deterioration due to the protective material may not occur. According to an embodiment, when the processed image has a specific pattern (e.g., a white pattern on a black background as in the second result 1320), the signal quality of the fingerprint sensor 200 is degraded, and the processor 120 may determine that the recognition performance of the fingerprint sensor 200 may be degraded.

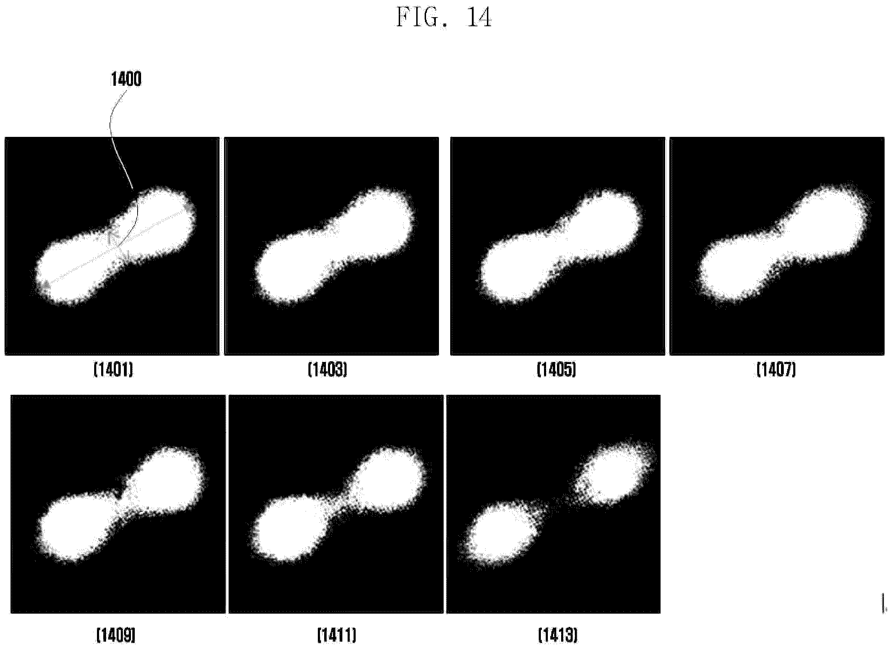

According to an embodiment, the processor 120 may identify (or distinguish) an additional characteristic (or feature) of the protective material, based on an image pattern that degrades the signal quality, examples of which are illustrated in FIG. 14 to FIG. 16.

FIG. 14 is a reference view illustrating an example of a change in a characteristic of a protective material in an electronic device according to an embodiment of the disclosure.

According to an embodiment, FIG. 14 may illustrate an example of a change in a characteristic of a processed image according to the thickness of a protective material. According to an embodiment, the processor 120 may determine a first characteristic (e.g., thickness information) of the protective material, based on the processed image.

According to an embodiment, a change in the thickness may be identified through a change in the middle width of an image pattern in the processed image. According to an embodiment, in FIG. 14, example 1401 may illustrate an example in which the protective material has a first thickness (e.g., basic thickness), example 1403 may illustrate an example in which the protective material has a second thickness (e.g., basic thickness x 2), example 1405 may illustrate an example in which the protective material has a third thickness (e.g., basic thickness x 3), example 1407 may illustrate an example in which the protective material has a fourth thickness (e.g., basic thickness x 4), example 1409 may illustrate an example in which the protective material has a fifth thickness (e.g., basic thickness x 5), example 1411 may illustrate an example in which the protective material has a sixth thickness (e.g., basic thickness x 6), and example 1413 may illustrate an example in which the protective material has a seventh thickness (e.g., base thickness x 7).

As illustrated in FIG. 14, it may be identified that the middle width 1400 of the image pattern decreases as the thickness of the protective material increases (e.g., from Example 1401 to Example 1413). For example, due to a change in the thickness of the protective material, the physical distance (or difference) between a retarding layer of the protective material and a polarizer 330 of a display 220 may change. In an embodiment, a signal overlap and/or a phase change due to a change in the physical distance may reduce the middle width of the image pattern. According to an embodiment, the processor 120 may infer a characteristic (e.g., thickness information (or characteristic)) of the protective material attached to the display 220 by using the value of the middle width of the image pattern in the processed image. According to an embodiment, the value of the middle width of the image pattern may be a width through the absolute number of pixels, or may be the ratio of the length in a major-axis direction.

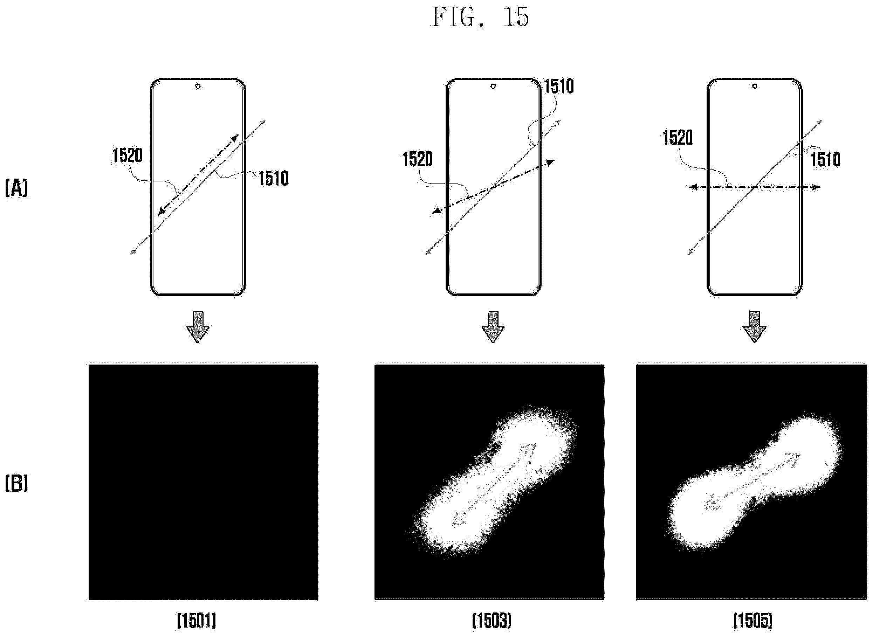

FIG. 15 is a reference view illustrating an example of a change in a characteristic of a protective material in an electronic device according to an embodiment of the disclosure.

According to an embodiment, FIG. 15 may illustrate an example of a change in a characteristic of a processed image according to the difference in polarization characteristic (e.g., direction) between a protective material and a display 220. According to an embodiment, the protective material may generally have a random retarding angle, and may have a different SNR degradation level. For example, an output image angle may change due to a change in retarding characteristic and polarizer characteristic. According to an embodiment, a processor 120 may determine a second characteristic (e.g., an image output angle according to the attachment angle of the protective material) of the protective material, based on the processed image. For example, the processor 120 may predict an SNR degradation level according to a change in the attachment angle of the protective material.

In an embodiment, in FIG. 15, element A may illustrate an example of the direction 1510 of a polarizer 330 of the display 220 and the retarding direction 1520 of the protective material. According to an embodiment, in FIG. 15, element B may illustrate an example of a processed image according to the angular difference between the direction 1510 of the polarizer 330 and the retarding direction 1520. For example, example 1501 may illustrate an example of a case where the direction 1510 of the polarizer 330 and the retarding direction 1520 of the protective material match. For example, example 1503 may illustrate an example of a case where the direction 1510 of the polarizer 330 and the retarding direction 1520 of the protective material have about a first angular difference (e.g., a difference of about 22.5 degrees). For example, example 1505 may illustrate an example of a case where the direction 1510 of the polarizer 330 and the retarding direction 1520 of the protective material have a second angular difference (e.g., a difference of about 45 degrees).

According to an embodiment, the processor 120 may identify a polarization characteristic (e.g., polarization direction) and a signal characteristic of the protective material through the entire angle of the processed image. According to an embodiment, when the retarding direction of the protective material and the polarization direction of the display 220 meet at a specific angle, the retarding direction of the protective material and the polarization direction of the display 220 may be combined to change the major-axis angle of the processed image. According to an embodiment, a general protective material may exhibit a polarization characteristic in a certain direction or a retarding characteristic in a random direction depending on a manufacturing method thereof. According to an embodiment, the processor 120 may infer the retarding direction 1520 of the protective material according to the processed image. According to an embodiment, the processor 120 may predict a final reduced signal level (e.g., SNR degradation level) through the difference between the retarding direction 1520 and the polarization direction 1510 of the polarizer 330.

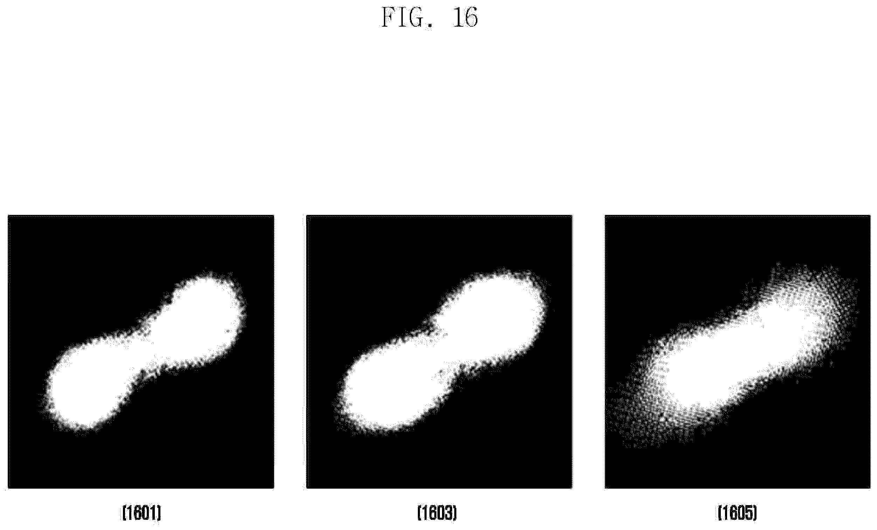

FIG. 16 is a reference view illustrating an example in which an electronic device distinguishes a characteristic of a protective material according to an embodiment of the disclosure.

According to an embodiment, FIG. 16 may illustrate an example of distinguishing a characteristic of a protective material (e.g., a first-type protective material, a second-type protective material, or a third-type protective material), based on a white area of an image pattern in a processed image.

According to an embodiment, in FIG. 16, example 1601 may illustrate an example of a processed image of an image obtained when the first-type protective material (e.g., a general-type protective material) is attached. According to an embodiment, in FIG. 16, example 1603 may illustrate an example of a processed image of an image obtained when the second-type protective material (e.g., a privacy-type protective material) is attached. According to an embodiment, in FIG. 16, example 1605 may illustrate an example of a processed image of an image obtained when the third-type protective material (e.g., an AR coating-type protective material) is attached.

According to an embodiment, the processor 120 may distinguish a characteristic (e.g., the type) of a protective material, based on a white area (e.g., the number of white pixels) in a processed image. For example, the processor 120 may distinguish a special protective material, such as a privacy type or an AR coating type, and a general-type protective material, based on the white area in the processed image.

According to an embodiment, the specially treated protective material, such as the privacy type or AR coating type, which is not a general protective material, may change not only a polarization characteristic but also a transmission characteristic. Therefore, in the specially treated protective material, diffuse reflection may internally occur to increase noise transmitted to a fingerprint sensor 200. Here, since diffusely reflected light is incident in a random direction rather than a vertical direction, compared to the general-type protective material, a wider area may appear in the processed image as illustrated in FIG. 16.

According to an embodiment, when a relatively wider area than an area appearing in the general-type protective material appears at a specified criterion or greater in the processed image, the processor 120 may distinguish the protective material as the special protective material.

According to an embodiment, the general protective material may reduce the SNR by up to about 50% since signal components may be reduced by up to about 50% due to a retarding characteristic and noise is constant. According to an embodiment, the specially treated protective material may reduce the SNR by up to about 90% due to a change in the transmission characteristic, an increase in noise component, a decrease in signal component, and an increase in noise.

According to an embodiment, when a relatively wider area than an area appearing in the general-type protective material appears at the specified criterion or greater in the processed image, the processor 120 may distinguish the protective material as the special protective material. For example, the processor 120 may distinguish the general protective material and the special protective material, based on a white area in the processed image.

According to an embodiment of the disclosure, the electronic device 101 may detect a protective material, based on an image (e.g., a fingerprint image) obtained while a user is actually using the electronic device 101, instead of a background image, and may determine whether the recognition performance of the fingerprint sensor 200 changes due to the protective material. For example, to obtain a background image, the electronic device 101 may conduct a performance test (e.g., the first performance test of FIG. 8) for the fingerprint sensor 200 in an environment similar to an environment for a calibration in a manufacturing stage, such as in control of an external light source that is introduced from the outside and acts as noise.

According to an embodiment of the disclosure, in an image obtained while the user is directly using the electronic device 101, the user's finger may shield an image acquisition area of the fingerprint sensor 200 from an external light source. According to an embodiment, the electronic device 101 may perform a performance test (e.g., the second performance test of FIG. 8) for the fingerprint sensor 200 by using an image (e.g., a fingerprint image) obtained without any restriction on a surrounding external light source. Hereinafter, an example of a method for performing the second performance test based on a fingerprint image will be described.

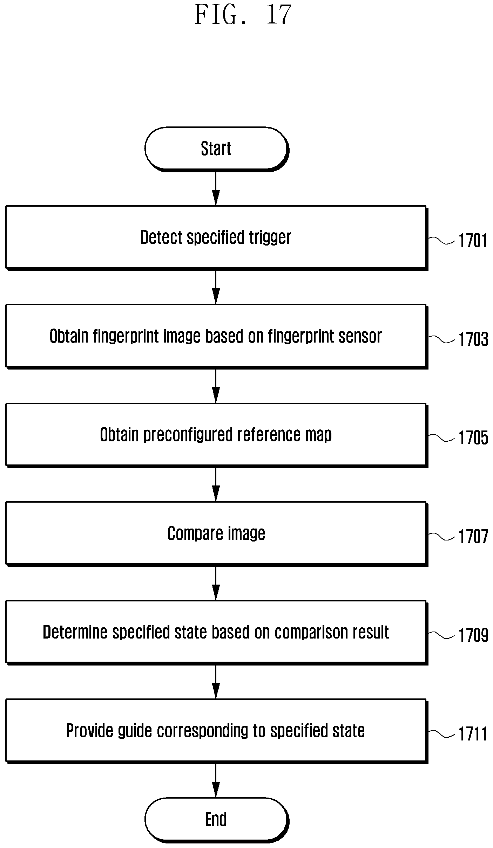

FIG. 17 is a flowchart illustrating an operating method of an electronic device according to an embodiment of the disclosure.

According to an embodiment, FIG. 17 may illustrate an example in which an electronic device 101 supports a performance test for the recognition performance of a fingerprint sensor 200 according to an embodiment. According to an embodiment, FIG. 17 may illustrate an example of an operation of performing a second performance test based on a fingerprint image. According to an embodiment, operations illustrated in FIG. 17 may be performed heuristically, for example, in combination with the operations illustrated in FIG. 7 to FIG. 10, or may be performed heuristically as detailed operations of at least some of the illustrated operations.

A method in which the electronic device 101 supports the performance test of the fingerprint sensor 200 according to an embodiment of the disclosure may be performed, for example, according to the flowchart illustrated in FIG. 17. The flowchart illustrated in FIG. 17 is merely a flowchart illustrating a performance text method of the electronic device 101 according to an embodiment, in which at least some operations may be performed in a different order, in parallel, or independently, or at least some other operations may be performed complementarily to the at least operations. According to an embodiment of the disclosure, operation 1701 to operation 1711 may be performed by at least one processor 120 of the electronic device 101.

As illustrated in FIG. 17, the operating method performed by the electronic device 101 according to an embodiment may include an operation 1701 of detecting a specified trigger, an operation 1703 of obtaining a fingerprint image based on the fingerprint sensor 200, an operation 1705 of obtaining a configured reference map, an operation 1707 of comparing the image, an operation 1709 of determining a specified state based on a comparison result, and an operation 1711 of providing a guide corresponding to the specified state.

Referring to FIG. 17, in operation 1701, the processor 120 of the electronic device 101 may detect a specified trigger (e.g., a second specified trigger). According to an embodiment, the processor 120 may detect the second specified trigger, based on a first situation (e.g., a user-intended situation) in which an input for a user to explicitly request the performance test of the fingerprint sensor 200 (e.g., to request execution of a performance test service (or application)) is received or a second situation (e.g., a user-unintended situation) in which a specified environment (or condition) for the performance test of the fingerprint sensor 200 is detected.

According to an embodiment, a second performance test for the fingerprint sensor 200 may be performed in a specified environment in which the user uses the electronic device 101. For example, the specified environment for the second performance test may include an environment in which the user uses the fingerprint sensor 200 (e.g., a fingerprint-based authentication operation, a fingerprint registration/re-registration operation, or a performance test execution request by the user).

According to an embodiment, the processor 120 may detect the second specified trigger, based on the first situation (user-intended situation), such as the user executing the performance test of the fingerprint sensor 200 in the electronic device 101. According to an embodiment, the processor 120 may guide the user to perform the performance test in the second situation (user-unintended situation), such as the user performing the fingerprint-based authentication operation or performing the fingerprint registration/re-registration operation. According to an embodiment, the processor 120 may detect the second specified trigger based on the first situation or the second situation.

According to an embodiment, the first situation (e.g., the user-intended situation) may include a situation in which the user explicitly executes the performance test, such as a case where the user directly selects a fingerprint recognition performance test item generated on a menu by using the electronic device 101. According to an embodiment, the second situation (e.g., the user-unintended situation) may include a situation in which the user does not explicitly execute the performance test, such as a case where the user starts a process of registering (or re-registering) a fingerprint by using the electronic device 101 and/or a case where fingerprint recognition performance data (e.g., the number of recognition failures) accumulated in the electronic device 101 exceeds a specified level, and a situation in which the user detects a specified environment while routinely using the electronic device 101.

In operation 1703, the processor 120 may obtain a fingerprint image, based on the fingerprint sensor 200. According to an embodiment, the processor 120 may detect the second specified trigger, based on the first situation or the second situation, and may control the fingerprint sensor 200 to capture a fingerprint image, based on detecting the second specified trigger. According to an embodiment, the fingerprint sensor 200 may capture at least one fingerprint image, based on control of the processor 120. According to an embodiment, the processor 120 may obtain at least one fingerprint image from the fingerprint sensor 200.

According to an embodiment, the processor 120 may obtain a specified number of fingerprint images. According to an embodiment, the processor 120 may control the operation of the fingerprint sensor 200 to obtain a plurality of fingerprint images at a specified time interval. An operation of obtaining the fingerprint images according to an embodiment may be the same as, for example, the operation described above with reference to FIG. 10, or may include an operation of obtaining a plurality of fingerprint images by a similar method.

In operation 1705, the processor 120 may obtain a configured reference map. According to an embodiment, the reference map may include numerical data obtained by digitizing (e.g., binarizing/ranging) an image pattern based on an averaged fingerprint image in the manufacturing stage of the electronic device 101. According to an embodiment, the reference map may be configured (or stored) in memory 130 in the manufacturing stage. According to an embodiment, the processor 120 may extract the reference map (e.g., second reference data) among various configured reference data from the memory 130 in response to detection of the second trigger related to the second performance test. In an embodiment, the reference map is described with reference to a drawing to be described below.

In operation 1707, the processor 120 may compare the image. According to an embodiment, the processor 120 may compare and analyze the obtained fingerprint image and the reference map corresponding to a configured reference fingerprint image. An operation of comparing and analyzing the image according to an embodiment is described with reference to a drawing to be described below.

In operation 1709, the processor 120 may determine a specified state, based on a comparison result. According to an embodiment, the specified state may include a state in which no protective material is attached (e.g., a first specified state in which the performance of the fingerprint sensor 200 is not affected), a state in which a protective material is attached but does not affect the performance of the fingerprint sensor 200 (e.g., a second specified state), and/or a state in which the protective material is attached and affects the performance of the fingerprint sensor 200 (e.g., a third specified state). According to an embodiment, the processor 120 may determine the specified state, based on whether the protective material is detected and an analysis of a characteristic of the protective material when the protective material is detected. An operation of determining the specified state according to an embodiment may be performed, for example, by the same method as described above with reference to FIG. 11 to FIG. 16.

In operation 1711, the processor 120 may provide a guide corresponding to the specified state. According to an embodiment, the processor 120 may provide various guides on a performance test result as described with reference to operation 711 of FIG. 7.

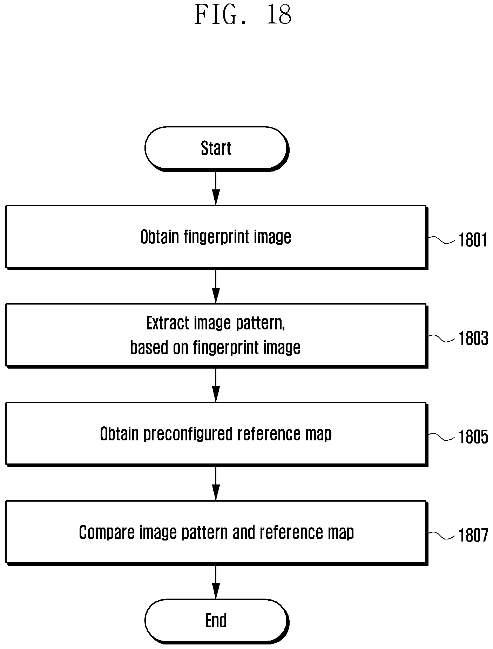

FIG. 18 is a flowchart illustrating an operating method of an electronic device according to an embodiment of the disclosure.

According to an embodiment, FIG. 18 may illustrate an example in which an electronic device 101 supports a performance test for the recognition performance of a fingerprint sensor 200 according to an embodiment. According to an embodiment, FIG. 18 may illustrate an example of an operation of comparing a reference map and converted data (e.g., an image pattern) of a fingerprint image in a second performance test based on the fingerprint image. According to an embodiment, operations illustrated in FIG. 18 may be performed heuristically, for example, in combination with the operations illustrated in FIG. 7 to FIG. 10 and/or FIG. 17, or may be performed heuristically as detailed operations of at least some of the illustrated operations.

A method in which the electronic device 101 supports the performance test of the fingerprint sensor 200 according to an embodiment of the disclosure may be performed, for example, according to the flowchart illustrated in FIG. 18. The flowchart illustrated in FIG. 18 is merely a flowchart illustrating a performance text method of the electronic device 101 according to an embodiment, in which at least some operations may be performed in a different order, in parallel, or independently, or at least some other operations may be performed complementarily to the at least operations. According to an embodiment of the disclosure, operation 1801 to operation 1807 may be performed by at least one processor 120 of the electronic device 101.

As illustrated in FIG. 18, the operating method performed by the electronic device 101 according to an embodiment may include an operation 1801 of obtaining a fingerprint image, an operation 1803 of extracting an image pattern, based on the fingerprint image, an operation 1805 of obtaining a configured reference map, and an operation 1807 of comparing the image pattern with the reference map.

Referring to FIG. 18, in operation 1801, the processor 120 of the electronic device 101 may obtain a fingerprint image. According to an embodiment, the processor 120 may control the fingerprint sensor 200 to capture a fingerprint image, based on detecting a second specified trigger. According to an embodiment, the fingerprint sensor 200 may capture at least one fingerprint image, based on control of the processor 120. According to an embodiment, the processor 120 may obtain at least one fingerprint image from the fingerprint sensor 200.

In operation 1803, the processor 120 may extract an image pattern, based on the fingerprint image. According to an embodiment, the processor 120 may extract an image pattern by binarizing/ranging the fingerprint image. For example, the image pattern may include numerical data obtained by binarizing/ranging the image pattern based on the obtained fingerprint image. According to an embodiment, the processor 120 may digitize an image area in a range corresponding to a reference map in the fingerprint image to compare the obtained fingerprint image with the reference map. For example, the processor 120 may convert each block into a specific numerical value by using a characteristic (e.g., the average, median, variance, and/or standard deviation) of pixel values in the corresponding range in each block.

In operation 1805, the processor 120 may obtain a configured reference map. According to an embodiment, the reference map may include numerical data obtained by binarizing/ranging an image pattern based on an averaged fingerprint image in the manufacturing stage of the electronic device 101. According to an embodiment, the reference map may be configured (or stored) in memory 130 in the manufacturing stage. According to an embodiment, the processor 120 may extract the reference map (e.g., second reference data) among various preconfigured reference data from the memory 130 in response to detection of a second trigger related to a second performance test.

In operation 1807, the processor 120 may compare the image pattern with the reference map. According to an embodiment, the processor 120 may perform image comparison by comparing the image pattern based on the obtained fingerprint image with the configured reference map.

According to an embodiment, the processor 120 may determine whether a protective material is attached, based on the result of comparing the image pattern with the reference map. According to an embodiment, the processor 120 may determine whether the protective material is attached, based on a calculated similarity value between the image pattern of the obtained fingerprint image and the reference map. According to an embodiment, the processor 120 may compare the calculated similarity value with a configured threshold value, and may determine whether the protective material is attached, based on the comparison result. According to an embodiment, when determining whether the protective material is attached, the processor 120 may provide a specified guide for the user. According to an embodiment, the processor 120 may provide the user with the guide as visual information through a message or a specified image.

According to an embodiment, the processor 120 may store, in the memory 130, collected data (e.g., a calculated value, an extracted image pattern, and/or a block pattern) collected while performing the second performance test. According to an embodiment, the processor 120 may provide the stored collected data as data about the performance test of the fingerprint sensor 200 according to the protective material. According to an embodiment, the processor 120 may update the reference map and/or the specified threshold value for improved performance by using the stored collected data.

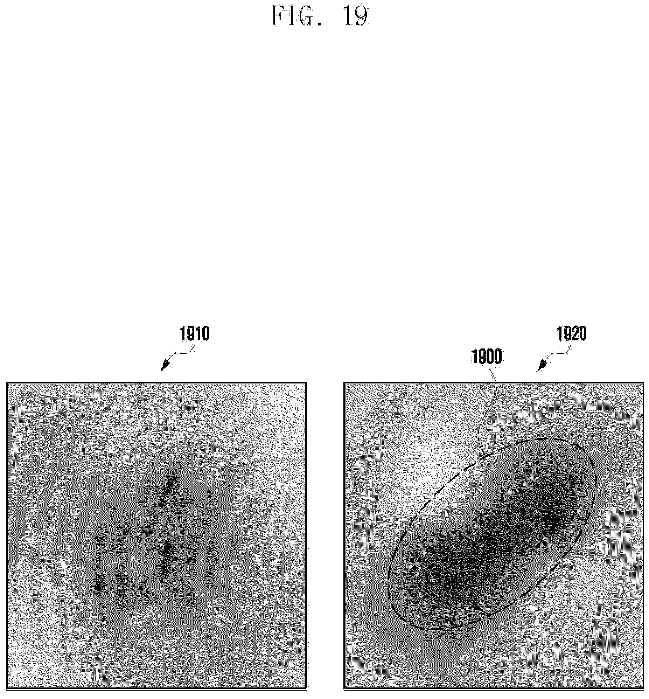

FIG. 19 is a reference view illustrating an example in which an electronic device detects a protective material by using a fingerprint image according to an embodiment of the disclosure.

According to an embodiment, FIG. 19 may illustrate an example of a fingerprint image obtained through a fingerprint sensor 200. According to an embodiment, FIG. 19 may illustrate an example of an operation of detecting whether a protective material is attached to a display 220 by using a fingerprint image during a comparative analysis operation.

According to an embodiment, FIG. 19 may illustrate an example of a fingerprint image (e.g., a first fingerprint image 1910 or a second fingerprint image 1920) captured by the fingerprint sensor 200 during a second performance test. According to an embodiment, the first fingerprint image 1910 illustrated in FIG. 19 may be an example of a fingerprint image captured by the fingerprint sensor 200 in the absence of the protective material (e.g., a state in which no protective material is attached to the display 220). According to an embodiment, the second fingerprint image 1920 illustrated in FIG. 19 may be an example of a fingerprint image captured by the fingerprint sensor 200 in the presence of the protective material (e.g., a state in which the protective material is attached to the display 220).

As illustrated in FIG. 19, it may be identified that there is a difference between the first fingerprint image 1910 in the absence of the protective substance and the second fingerprint image 1920 in the presence of the protective substance.

According to an embodiment, the fingerprint image (e.g., the first fingerprint image 1910 or the second fingerprint image 1920) may use an image obtained during fingerprint authentication by a user using the electronic device 101. According to an embodiment, as illustrated in FIG. 19, a specific pattern, as described above in relation to a background image, may appear in the fingerprint image depending on whether the protective material is attached. For example, in the first fingerprint image 1910 obtained in the state in which no protective material is attached, only a pattern corresponding to a fingerprint may exist. For example, in the second fingerprint image 1920 obtained in the state in which the protective material is attached, a pattern due to the protective material may be further included in addition to the pattern corresponding to the fingerprint. For example, as illustrated in FIG. 19, in the second fingerprint image 1920, it may be identified that a dark pattern 1900 is further included in the middle of the image.

According to an embodiment, the specific pattern corresponding to the protective material may also exist in a fingerprint image obtained when the user routinely uses the electronic device 101. For example, as described above with reference to the background image, the specific pattern may be generated due to combination of a retarding characteristic of the protective material and a polarization characteristic of the display 220.

According to an embodiment, a processor 120 may detect whether the protective material is attached, based on the specific pattern in a general usage environment of the electronic device 101. According to an embodiment, the electronic device 101 may configure a reference map including pattern information and characteristics of the protective material for detecting an image pattern from the fingerprint image, and store the reference map in memory 130. According to an embodiment, the processor 120 may perform numerical determination by comparing an image pattern from a fingerprint image with the reference map. For example, the processor 120 may determine whether the protective material is attached, based at least on the difference, similarity, and/or pattern difference between the image pattern and the reference map.

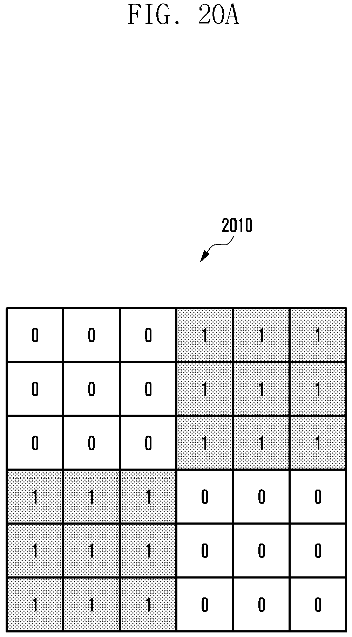

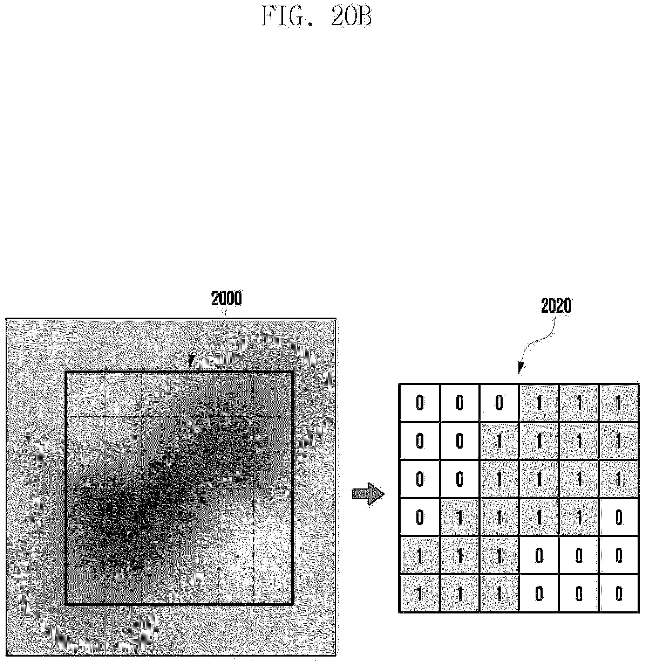

According to an embodiment, the processor 120 may extract the image pattern (e.g., a comparison image) for comparison with the reference map from the fingerprint image. According to an embodiment, the image pattern may be extracted based on an area including a range in which a specific image pattern appearing due to the protective material appears in the obtained fingerprint image. According to an embodiment, the processor 120 may block the area including the range in which the specific image pattern appears, and may extract an image pattern in the same form as the reference map by using the blocked image, an example of which is illustrated in FIG. 20A and FIG. 20B.

FIG. 20A and FIG. 20B are reference views illustrating an example of an image pattern extracted based on a reference map and a fingerprint image in an electronic device according to an embodiment of the disclosure.

According to an embodiment, FIG. 20A may illustrate an example of a reference map 2010. According to an embodiment, FIG. 20B may illustrate an example of an image pattern 2020 (e.g., a binarized/ranged pattern) extracted from a fingerprint image.

As illustrated in FIG. 20A and FIG. 20B, the reference map and the image pattern may include, for example, a set 2000 of blocks in the form of an n x m matrix. According to an embodiment, each block in the set 2000 of blocks may include of a set of pixels of the obtained fingerprint image. For example, a x b pixels may be grouped to form one block, and n x m blocks may be grouped to form the reference map and/or the image pattern. For example, the reference map may include n x m blocks including consecutive sets of a x b pixels (e.g., 6 x 6 blocks including 30 x 30 pixels). In an embodiment, there may be only one reference map, or a plurality of reference maps having one or more different blocks and the number of pixels per block may be stored and compared with the extracted image pattern.

According to an embodiment, as illustrated in FIG. 20A, the reference map 2010 may refer to information expressed in the form of numerical data including a feature of the fingerprint image obtained in a state in which a protective material is applied to a display 220 of the electronic device 101. According to an embodiment, a specified value may be input in the manufacturing stage of the electronic device 101. According to an embodiment, the input specified value (e.g., a numerical value) may be updated based on various data. According to an embodiment, the input specified value (e.g., the numerical value) may be updated and optimized according to user data. For example, the electronic device 101 may learn user data through machine learning, and may update the numerical value, based on the learned user data.

According to an embodiment, the reference map 2010 may have a characteristic of the protective material. Accordingly, as the obtained image pattern 2020 is more similar to an image pattern of the reference map 2010, the protective material may be determined as being attached.

According to an embodiment, as illustrated in FIG. 20B, the extracted image pattern 2020 may have a size equal to or smaller than that of the original fingerprint image. According to an embodiment, one block in the extracted image pattern 2020 may include one or more sets of pixels.

According to an embodiment, the value of each block may be binarized (e.g., 0/1, -1, 0, 1) or ranged (e.g., x to y) and be input. According to an embodiment, the value of the block may be determined by various methods as in the following examples. According to an embodiment, the average of all pixels in the block may be calculated, compared with the average of the blocks, and binarized/ranged, thereby determining the value of the block. According to an embodiment, the blocks may be grouped into a specific number of blocks, the average of pixels in a corresponding range may be calculated, and then a block in the corresponding range may be binarized/ranged, thereby determining the value of the block. According to an embodiment, a fixed threshold value may be specified and compared with the average of pixels in each block or with each pixel, and then the block may be binarized/ranged, thereby determining the value of the block. According to an embodiment, the square of the average value and the difference value of all blocks or some blocks may be determined and binarized/ranged, thereby determining the value of the block. The disclosure is not limited to the above methods, and various other methods may be used in addition to the above example according to an embodiment.

For example, when blocking the image pattern extracted from the original fingerprint image, the image pattern may be expressed as one numerical value by using numerical information of each pixel in each block, such as the average, median, variance/standard deviation, frequency, and/or contrast of pixel values in the block, and the numerical value may be binarized/ranged, thereby determining the value of the block.

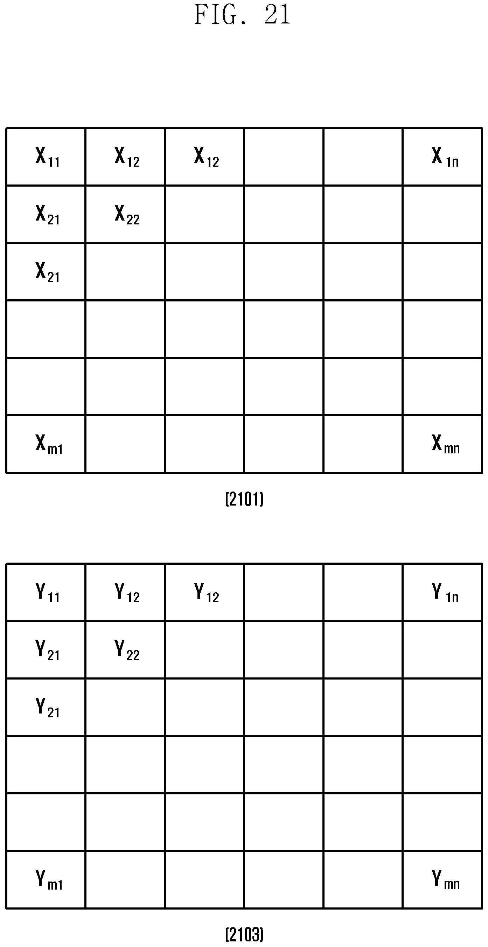

According to an embodiment, the processor 120 may compare the value of the block determined above by binarization/ranging with the reference map, an example of which is illustrated in FIG. 21.

FIG. 21 is a reference view illustrating an example in which an electronic device compares an image pattern based on a fingerprint image with a reference map according to an embodiment of the disclosure.

According to an embodiment, example 2101 may be an example of an image pattern extracted from a fingerprint image. According to an embodiment, example 2103 may be an example of a reference map.

According to an embodiment, as illustrated in FIG. 21, a processor 120 may compare the extracted image pattern with the reference map. According to an embodiment, the processor 120 may compare the image pattern with the reference map, for example, using a difference value or a correlation, thereby determining similarity therebetween.

According to an embodiment, determination of the similarity using the difference value may use the difference value in block value between the reference map and the extracted image pattern. For example, a comparison value may be calculated by combining equations, such as the average, absolute value, total sum, and/or square of the difference value between corresponding blocks. According to an embodiment, the processor 120 may determine similarity between the values of the blocks through the equations, thereby determining the similarity between the extracted image pattern and the reference map.

According to an embodiment, determination of the similarity using the correlation may use a specified correlation equation. For example, the correlation may indicate a method of determining the degree of similarities between two groups (e.g., the extracted image pattern and the reference map). According to an embodiment, the correlation may be generally defined as follows.

$$[\text{Equation 1}]$$

$$r = \frac{\sum (X - \overline{X})(Y - \overline{Y})}{\sqrt{\sum (X - \overline{X})^2}\sqrt{(Y - \overline{Y})^2}}$$

As illustrated in Equation 1, the correlation r may be obtained by dividing, by the standard deviation of each group (e.g., $\sqrt{\sum (X - \overline{X})^2}$, $\sqrt{(Y - \overline{Y})^2}$), the sum of the results of multiplying the results of subtracting the averages of the two groups respectively from the factors of the groups. According to an embodiment, the correlation r may be obtained as a value ranging from -1 to 1. For example, "1" may represent that the two groups are the same image, and "-1" may represent that the two groups are inverted images. In an embodiment, when the correlation r is "1", the processor 120 may determine that the image pattern and the reference map are the same image, and when the correlation r is "-1", the processor 120 may determine that the image pattern and the reference map are different images. According to an embodiment, the processor 120 may determine whether a protective material is attached, based on the correlation r.

According to an embodiment, a specific threshold value may be configured, and the processor 120 may determine whether the protective material is attached through the calculated correlation r and the specified threshold value. For example, when the correlation r is generally about 0.5 or greater, the processor 120 may determine that there is a similar pattern and a high correlation, an example of which is described with reference to Table 1.

[Table 1]

|  | Fingerprint1 | Fingerprint2 | Fingerprint3 | Fingerprint4 | Fingerprint5 | Average |
|---|---|---|---|---|---|---|
| No Film | -0.11 | 0.27 | 0.00 | -0.23 | 0.12 | 0.01 |
| Film No. 1 | 0.89 | 0.89 | 0.84 | 0.84 | 0.89 | 0.87 |
| Film No. 2 | 0.84 | 0.89 | 0.95 | 0.84 | 0.89 | 0.88 |
| Film No. 3 | 0.63 | 0.61 | 0.73 | 0.5 | 0.5 | 0.59 |

According to an embodiment, Table 1 may illustrate an example of correlations of five fingerprint images obtained through a fingerprint sensor 200 in a state in which a protective material (e.g., a protective film) is not attached and in a state where different protective materials are attached. For example, Table 1 may illustrate a value obtained by binarizing the illustrative fingerprint images and then calculating the correlations thereof with a specific reference map. As illustrated in Table 1, it may be identified that the fingerprint images have a higher correlation value in three states in which a protective material is attached than in the state in which no protective material is attached.

According to an embodiment, the correlation values may be changed according to the block size or number of each image pattern in addition to a binarization/ranging method for the extracted block.

An operating method performed by an electronic device 101 according to an embodiment of the disclosure may include detecting a specified trigger related to a performance test of a fingerprint sensor disposed under a display, controlling the fingerprint sensor to obtain a specified image, based on detecting the specified trigger, extracting reference data configured in memory of the electronic device, determining a state related to a protective material attachable onto the display, based on the specified image obtained through the fingerprint sensor and the reference data, determining whether performance of the fingerprint sensor is changed, based on the state related to the protective material, and performing a specified operation, based on whether the performance of the fingerprint sensor is changed.

According to an embodiment, the specified trigger may include a first trigger for performing a first performance test based on a background image obtained in a specified environment. According to an embodiment, the specified trigger may include a second trigger for performing a second performance test based on a fingerprint image obtained in a usage environment of the electronic device.

According to an embodiment, the operating method performed by the electronic device 101 may include identifying a type of the specified trigger, based on a performance test environment, performing the first performance test by using the background image, based on determining that the specified trigger is the first trigger, and performing the second performance test by using the fingerprint image, based on determining that the specified trigger is the second trigger.

According to an embodiment, the performing of the first performance test may include obtaining the background image through the fingerprint sensor in the specified environment, obtaining first reference data configured in the memory, and detecting whether the protective material is attached, based on comparison between the background image and the first reference data. According to an embodiment, the first reference data may include at least one reference background image obtained using a specified calibration kit in a calibration of the fingerprint sensor. According to an embodiment, the specified environment may include a similar environment corresponding to an environment of the calibration of the fingerprint sensor.

According to an embodiment, the obtaining of the background image may include obtaining a plurality of background images at a specified regular time interval and determining similarity between the plurality of background images.

According to an embodiment, the performing of the second performance test may include obtaining the fingerprint image through the fingerprint sensor, extracting an image pattern, based on the fingerprint image, obtaining second reference data configured in the memory, and detecting whether the protective material is attached, based on comparison between the image pattern and the second reference data. According to an embodiment, the second reference data may include at least one reference map obtained by digitizing an image pattern extracted based on an averaged fingerprint image in a calibration of the fingerprint sensor.

According to an embodiment, the extracting of the image pattern may include extracting the image pattern by digitizing an image area in a range corresponding to the reference map in the fingerprint image.

According to an embodiment, the determining whether the performance is changed may include determining whether there is the protective material on the display, based on the specified image and the reference data, analyzing a characteristic of the protective material when determining that there is the protective material, and determining whether the performance of the fingerprint sensor is changed, based on the characteristic of the protective material.

Various embodiments of the disclosure disclosed in the specification and drawings are provided as specific examples to easily explain the technical content of the disclosure and to facilitate understanding of the disclosure, and are not intended to limit the scope of the disclosure. Accordingly, the scope of the disclosure should be construed as including all changes or modifications derived based on the technical idea of the disclosure in addition to the embodiments disclosed herein.

**Claims**

1. An electronic device comprising:

   a display;
   a fingerprint sensor disposed below the display;
   memory; and
   a processor operatively connected to the display, the fingerprint sensor, and the memory,
   wherein the processor is configured to:

   detect a specified trigger related to a performance test of the fingerprint sensor;
   control the fingerprint sensor to obtain a specified image, based on detecting the specified trigger;
   extract reference data configured in the memory;
   determine a state related to a protective material attachable onto the display, based on the specified image obtained through the fingerprint sensor and the reference data;
   determine whether performance of the fingerprint sensor is changed, based on the state related to the protective material; and
   perform a specified operation, based on whether the performance of the fingerprint sensor is changed.

2. The electronic device of claim 1, wherein the processor is configured to detect the specified trigger, based on a first situation based on reception of a user input for the performance test or a second situation based on detection of a specified environment for the performance test.

3. The electronic device of claim 1, wherein the specified trigger comprises:

   a first trigger for performing a first performance test based on a background image obtained in a specified environment; and
   a second trigger for performing a second performance test based on a fingerprint image obtained in a usage environment of the electronic device.

4. The electronic device of claim 3, wherein the processor is configured to:

   identify a type of the specified trigger, based on a performance test environment;
   perform the first performance test by using the background image, based on determining that the specified trigger is the first trigger; and
   perform the second performance test by using the fingerprint image, based on determining that the specified trigger is the second trigger.

5. The electronic device of claim 4, wherein the processor is configured to:

   obtain the background image through the fingerprint sensor in the specified environment;
   obtain first reference data configured in the memory; and
   detect whether the protective material is attached, based on comparison between the background image and the first reference data, and

wherein the first reference data comprises at least one reference background image obtained using a specified calibration kit in a calibration of the fingerprint sensor.

6. The electronic device of claim 5, wherein the processor is configured to:

   obtain a plurality of background images at a specified regular time interval; and
   determine similarity between the plurality of background images.

7. The electronic device of claim 5, wherein the processor is configured to obtain the background image in a similar environment corresponding to an environment of the calibration of the fingerprint sensor, based on a sensor module of the electronic device.

8. The electronic device of claim 4, wherein the processor is configured to:

   obtain the fingerprint image through the fingerprint sensor;
   extract an image pattern, based on the fingerprint image;
   obtain second reference data configured in the memory; and
   detect whether the protective material is attached, based on comparison between the image pattern and the second reference data, and
   wherein the second reference data comprises at least one reference map obtained by digitizing an image pattern extracted based on an averaged fingerprint image in a calibration of the fingerprint sensor.

9. The electronic device of claim 8, wherein the processor is configured to extract the image pattern by digitizing an image area in a range corresponding to the reference map in the fingerprint image.

10. The electronic device of claim 8, wherein the processor is configured to:

    calculate similarity between the image pattern and the second reference data;
    compare the calculated similarity with a specified threshold value; and
    determine that there is the protective material on the display when the similarity is the specified threshold value or greater.

11. The electronic device of claim 1, wherein the processor is configured to:

    determine whether there is the protective material on the display, based on the specified image and the reference data;
    analyze a characteristic of the protective material when determining that there is the protective material; and
    determine whether the performance of the fingerprint sensor is changed, based on the characteristic of the protective material.

12. The electronic device of claim 11, wherein the processor is configured to:

    determine a first specified state in which the performance of the fingerprint sensor is not changed when determining that there is no protective material;
    determine a second specified state in which the performance of the fingerprint sensor is not changed or a third specified state in which the performance of the fingerprint sensor is changed, based on the characteristic of the protective material when determining that there is the protective material; and
    provide a specified guide related to the protective material corresponding to the determined specified state.

13. An operating method of an electronic device, the operating method comprising:

    detecting a specified trigger related to a performance test of a fingerprint sensor disposed under a display;
    controlling the fingerprint sensor to obtain a specified image, based on detecting the specified trigger;
    extracting reference data preconfigured in memory of the electronic device;
    determining a state related to a protective material attachable onto the display, based on the specified image obtained through the fingerprint sensor and the reference data;
    determining whether performance of the fingerprint sensor is changed, based on the state related to the protective material; and

performing a specified operation, based on whether the performance of the fingerprint sensor is changed.

14. The operating method of claim 13, wherein the specified trigger comprises:

a first trigger for performing a first performance test based on a background image obtained in a specified environment; and
a second trigger for performing a second performance test based on a fingerprint image obtained in a usage environment of the electronic device.

15. The operating method of claim 13, comprising:

identifying a type of the specified trigger, based on a performance test environment;
performing the first performance test by using the background image, based on determining that the specified trigger is a first trigger; and
performing the second performance test by using the fingerprint image, based on determining that the specified trigger is a second trigger.

# FIG. 1

ELECTRONIC DEVICE 101

INPUT MODULE 150

SOUND OUTPUT MODULE 155

BATTERY 189

POWER MANAGEMENT MODULE 188

AUDIO MODULE 170

HAPTIC MODULE 179

DISPLAY MODULE 160

PROCESSOR 120
MAIN PROCESSOR 121
AUXILIARY PROCESSOR 123

SENSOR MODULE 176

CAMERA MODULE 180

MEMORY 130
VOLATILE MEMORY 132
NON-VOLATILE MEMORY 134
INTERNAL MEMORY 136
EXTERNAL MEMORY 138

COMMUNICATION MODULE 190
WIRELESS COMMUNICATION MODULE 192
WIRED COMMUNICATION MODULE 194

SUBSCRIBER IDENTIFICATION MODULE 196

ANTENNA MODULE 197

INTERFACE 177

CONNECTION TERMINAL 178

PROGRAM 140
APPLICATIONS 146
MIDDLEWARE 144
OPERATING SYSTEM 142

100

SECOND NETWORK 199

ELECTRONIC DEVICE 104

FIRST NETWORK 198

ELECTRONIC DEVICE 102

SERVER 108

EP 4 557 247 A1

# FIG. 2

# FIG. 3

FIG. 4

FIG. 5

(501)

(503)

(505)

(507)

# FIG. 6

101

Fingerprint sensor — 200

120 — Processor

Sensor module — 260

130 — Memory

Illuminance sensor — 261

220 — Display

Acceleration sensor — 263

270 — Camera module

Gyro sensor — 265

Atmospheric pressure sensor — 267

⋮

# FIG. 7

```
                    ( Start )
                        |
                        v
+----------------------------------------------+
| Detect specified trigger related to          |~ 701
| performance test of fingerprint sensor       |
+----------------------------------------------+
                        |
                        v
+----------------------------------------------+
| Obtain image, based on fingerprint sensor    |~ 703
+----------------------------------------------+
                        |
                        v
+----------------------------------------------+
| Extract preconfigured reference data         |~ 705
+----------------------------------------------+
                        |
                        v
+----------------------------------------------+
| Analyze state, based on obtained image       |~ 707
| and reference data                           |
+----------------------------------------------+
                        |
                        v
+----------------------------------------------+
| Determine specified state, based on state    |~ 709
| analysis result                              |
+----------------------------------------------+
                        |
                        v
+----------------------------------------------+
| Perform specified operation, based on        |~ 711
| specified state                              |
+----------------------------------------------+
                        |
                        v
                    ( End )
```

# FIG. 8

```
                    ( Start )
                        |
                        v
            +-------------------------+  801
            |  Detect specified trigger |
            +-------------------------+
                        |
                        v
            +-------------------------+  803
            | Identify type of specified trigger |
            +-------------------------+
                        |
                        v
                     /‾‾‾‾‾\   805
                    /       \
                   / First   \      NO
                   \ trigger? /----------------------+
                    \       /                        |
                     \_____/                         |
                        | YES       807              |        809
                        v                            v
        +--------------------------+    +--------------------------+
        | Perform first performance |    | Perform second performance |
        | test based on background  |    | test based on fingerprint  |
        | image                     |    | image                      |
        +--------------------------+    +--------------------------+
                        |                            |
                        v<---------------------------+
        +--------------------------+  811
        | Provide guide corresponding to |
        | performance test result    |
        +--------------------------+
                        |
                        v
                    (  End  )
```

# FIG. 9

```
         ┌─────────────┐
         │    Start    │
         └─────────────┘
                │
                ▼
  ┌──────────────────────────────┐
  │    Detect specified trigger  │ ～901
  └──────────────────────────────┘
                │
                ▼
  ┌──────────────────────────────┐
  │    Obtain background image,  │ ～903
  │   based on fingerprint sensor│
  └──────────────────────────────┘
                │
                ▼
  ┌──────────────────────────────┐
  │ Obtain preconfigured reference│ ～905
  │      background image        │
  └──────────────────────────────┘
                │
                ▼
  ┌──────────────────────────────┐
  │   Compare background images  │ ～907
  └──────────────────────────────┘
                │
                ▼
  ┌──────────────────────────────┐
  │   Determine specified state, │ ～909
  │   based on comparison result │
  └──────────────────────────────┘
                │
                ▼
  ┌──────────────────────────────┐
  │  Provide guide corresponding to│ ～911
  │       specified state        │
  └──────────────────────────────┘
                │
                ▼
         ┌─────────────┐
         │     End     │
         └─────────────┘
```

# FIG. 10

Start

Obtain plurality of background images, based on fingerprint sensor  1001

Compare similarity between background images  1003

Is specified condition satisfied?  1005

NO

YES  1009

Compare background images

Perform specified operation  1007

End

FIG. 11A

FIG. 11B

FIG. 12

1210

1220

FIG. 13

1310

1320

FIG. 14

FIG. 15

FIG. 16

[1601]　[1603]　[1605]

# FIG. 17

```
                    ┌─────────────┐
                    │    Start    │
                    └──────┬──────┘
                           │
                           ▼
        ┌──────────────────────────────────────────┐
        │           Detect specified trigger        │────  1701
        └────────────────────┬─────────────────────┘
                             │
                             ▼
        ┌──────────────────────────────────────────┐
        │  Obtain fingerprint image based on fingerprint sensor │────  1703
        └────────────────────┬─────────────────────┘
                             │
                             ▼
        ┌──────────────────────────────────────────┐
        │        Obtain preconfigured reference map  │────  1705
        └────────────────────┬─────────────────────┘
                             │
                             ▼
        ┌──────────────────────────────────────────┐
        │              Compare image                 │────  1707
        └────────────────────┬─────────────────────┘
                             │
                             ▼
        ┌──────────────────────────────────────────┐
        │  Determine specified state based on comparison result │────  1709
        └────────────────────┬─────────────────────┘
                             │
                             ▼
        ┌──────────────────────────────────────────┐
        │  Provide guide corresponding to specified state │────  1711
        └────────────────────┬─────────────────────┘
                             │
                             ▼
                    ┌─────────────┐
                    │     End     │
                    └─────────────┘
```

# FIG. 18

```
                        ┌─────────────┐
                        │    Start    │
                        └─────────────┘
                               │
                               ▼
      ┌──────────────────────────────────────────┐
      │         Obtain fingerprint image          │ ～1801
      └──────────────────────────────────────────┘
                               │
                               ▼
      ┌──────────────────────────────────────────┐
      │            Extract image pattern,         │ ～1803
      │          based on fingerprint image       │
      └──────────────────────────────────────────┘
                               │
                               ▼
      ┌──────────────────────────────────────────┐
      │        Obtain preconfigured reference map │ ～1805
      └──────────────────────────────────────────┘
                               │
                               ▼
      ┌──────────────────────────────────────────┐
      │     Compare image pattern and reference map│ ～1807
      └──────────────────────────────────────────┘
                               │
                               ▼
                        ┌─────────────┐
                        │     End     │
                        └─────────────┘
```

FIG. 19

FIG. 20A

2010

| 0 | 0 | 0 | 1 | 1 | 1 |
|---|---|---|---|---|---|
| 0 | 0 | 0 | 1 | 1 | 1 |
| 0 | 0 | 0 | 1 | 1 | 1 |
| 1 | 1 | 1 | 0 | 0 | 0 |
| 1 | 1 | 1 | 0 | 0 | 0 |
| 1 | 1 | 1 | 0 | 0 | 0 |

# FIG. 20B

# FIG. 21

| $X_{11}$ | $X_{12}$ | $X_{12}$ | | | $X_{1n}$ |
|---|---|---|---|---|---|
| $X_{21}$ | $X_{22}$ | | | | |
| $X_{21}$ | | | | | |
| | | | | | |
| | | | | | |
| $X_{m1}$ | | | | | $X_{mn}$ |

(2101)

| $Y_{11}$ | $Y_{12}$ | $Y_{12}$ | | | $Y_{1n}$ |
|---|---|---|---|---|---|
| $Y_{21}$ | $Y_{22}$ | | | | |
| $Y_{21}$ | | | | | |
| | | | | | |
| | | | | | |
| $Y_{m1}$ | | | | | $Y_{mn}$ |

(2103)

## INTERNATIONAL SEARCH REPORT

| International application No. |
| --- |
| **PCT/KR2023/008953** |

| | |
| --- | --- |
| **A.** | **CLASSIFICATION OF SUBJECT MATTER** |
| | **G06V 40/13**(2022.01)i; **G06V 10/776**(2022.01)i |

According to International Patent Classification (IPC) or to both national classification and IPC

| | |
| --- | --- |
| **B.** | **FIELDS SEARCHED** |

Minimum documentation searched (classification system followed by classification symbols)

G06V 40/13(2022.01); G01R 1/02(2006.01); G01R 31/28(2006.01); G06F 3/041(2006.01); G06K 9/00(2006.01); G06Q 10/10(2012.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 지문(fingerprint), 성능(performance), 검사(test), 센서(sensor), 보호(protect), 전자장치(electronic device)

| | |
| --- | --- |
| **C.** | **DOCUMENTS CONSIDERED TO BE RELEVANT** |

| Category* | Citation of document, with indication, where appropriate, of the relevant passages | Relevant to claim No. |
| --- | --- | --- |
| A | KR 10-1651570 B1 (S-TECHNOLOGY CO., LTD.) 05 September 2016 (2016-09-05) <br> See claims 1 and 8. | 1-15 |
| A | KR 10-2017-0043404 A (SAMSUNG ELECTRONICS CO., LTD.) 21 April 2017 (2017-04-21) <br> See entire document. | 1-15 |
| A | KR 10-2058268 B1 (OH, Sea Jeong) 20 December 2019 (2019-12-20) <br> See claim 1. | 1-15 |
| A | US 2019-0057237 A1 (SHENZHEN GOODIX TECHNOLOGY CO., LTD.) 21 February 2019 (2019-02-21) <br> See entire document. | 1-15 |
| A | KR 10-2020-0034336 A (LG DISPLAY CO., LTD.) 31 March 2020 (2020-03-31) <br> See claims 1-8. | 1-15 |

| ☐ Further documents are listed in the continuation of Box C. | ☑ See patent family annex. |
| --- | --- |

| | | | |
| --- | --- | --- | --- |
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
| --- | --- |
| **04 October 2023** | **04 October 2023** |

| Name and mailing address of the ISA/KR | Authorized officer |
| --- | --- |
| **Korean Intellectual Property Office** <br> **Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

**INTERNATIONAL SEARCH REPORT**
Information on patent family members

International application No.

**PCT/KR2023/008953**

| Patent document cited in search report | | | Publication date (day/month/year) | Patent family member(s) | | | Publication date (day/month/year) |
|---|---|---|---|---|---|---|---|
| KR | 10-1651570 | B1 | 05 September 2016 | KR | 10-2015-0124199 | A | 05 November 2015 |
| KR | 10-2017-0043404 | A | 21 April 2017 | KR | 10-2365412 | B1 | 21 February 2022 |
| | | | | US | 10192045 | B2 | 29 January 2019 |
| | | | | US | 2017-0103195 | A1 | 13 April 2017 |
| KR | 10-2058268 | B1 | 20 December 2019 | KR | 10-2018-0107497 | A | 02 October 2018 |
| US | 2019-0057237 | A1 | 21 February 2019 | CN | 107690653 | A | 13 February 2018 |
| | | | | CN | 107690653 | B | 10 December 2021 |
| | | | | EP | 3462374 | A1 | 03 April 2019 |
| | | | | EP | 3462374 | A4 | 03 April 2019 |
| | | | | KR | 10-2019-0031416 | A | 26 March 2019 |
| | | | | US | 10579853 | B2 | 03 March 2020 |
| | | | | WO | 2019-033386 | A1 | 21 February 2019 |
| KR | 10-2020-0034336 | A | 31 March 2020 | CN | 110941981 | A | 31 March 2020 |
| | | | | CN | 110941981 | B | 23 May 2023 |
| | | | | US | 11120242 | B2 | 14 September 2021 |
| | | | | US | 2020-0097698 | A1 | 26 March 2020 |

Form PCT/ISA/210 (patent family annex) (July 2022)